# EUROPÄISCHE PATENTSCHRIFT

(11) **EP 2 820 673 B1**
(45) Veröffentlichungstag und Bekanntmachung des Hinweises auf die Patenterteilung: **16.11.2016**
(21) Anmeldenummer: 12816652.7
(22) Anmeldetag: 22.12.2012
(51) Int. Cl.: H01L 23/495

(54) **SUBSTRAT MIT VERGRÖSSERTER CHIPINSEL**
SUBSTRATE WITH ENLARGED CHIP ISLAND
SUBSTRAT COMPORTANT UN ILOT POUR PUCES AGRANDI

(30) Priorität: 29.02.2012 DE 102012101645; 24.04.2012 DE 102012103583
(43) Veröffentlichungstag der Anmeldung: 07.01.2015
(73) Patentinhaber: Heraeus Deutschland GmbH & Co. KG, 63450 Hanau (DE)
(72) Erfinder: WALTER, Siegfried, 63571 Gelnhausen-Höchst (DE); DITZEL, Eckhard, 63589 Linsengericht (DE)
(74) Vertreter: Schultheiss & Sterzel Patentanwälte PartG mbB
(86) Internationale Anmeldenummer: PCT/EP2012/005365
(87) Internationale Veröffentlichungsnummer: WO 2013/127420

(56) Entgegenhaltungen:
- EP-A2- 1 329 952
- DE-A1-102010 005 771
- JP-A- 6 283 627
- US-A1- 2008 265 248

## Beschreibung

Die Erfindung betrifft ein bandförmiges Trägersubstrat zur Montage mehrerer Halbleiterchips umfassend eine elektrisch leitende Schicht, die durch Ausnehmungen in den Schichten strukturiert ist, wobei die Ausnehmungen mehrere gleichförmige Einheiten im Trägersubstrat bilden und jede Einheit eine Aufnahmefläche zur Montage zumindest eines Halbleiterchips, einen Restbereich und zwei Elektroden zur Kontaktierung des Halbleiterchips umfasst, die durch die Ausnehmungen vorstrukturiert sind, wobei die Aufnahmeflächen zwischen den Elektroden der gleichen Einheit angeordnet sind und das Trägersubstrat durch eine Parkettierung der Einheiten gebildet ist.

Die Erfindung betrifft auch ein elektronisches Bauelement umfassend zwei Elektroden und eine Aufnahmefläche hergestellt, insbesondere freigestanzt aus einem solchen Trägersubstrat und ein Verfahren zur Herstellung eines bandförmigen Trägersubstrats, zur Herstellung von Substraten für die Halbleiterchip-Montage oder elektronischen Bauelementen, sowie ein Verfahren zur Herstellung eines elektronischen Bauelements.

Bandförmige Trägersubstrate werden zur Massenherstellung von elektronischen Bauelementen verwendet, bei denen eine Vielzahl gleichartiger elektronischer Bauelemente aus dem bandförmigen Trägersubstrat hergestellt werden. Dazu werden zunächst Halbleiterchips mit dem Trägersubstrat verbunden und diese Strukturen später vereinzelt. Solche Trägersubstrate sind in Einheiten unterteilt, die später die Teile eines elektronischen Elements bilden und die der Anordnung und Kontaktierung eines Halbleiterchips dienen. Die Einheiten können Elektroden und Aufnahmeflächen für die Halbleiterchips umfassen, die durch Ausnehmungen vorstrukturiert sind und die durch Stanzen oder Schneiden erzeugt werden können. Dadurch können bei der Endfertigung der elektronischen Bauelemente, nach dem Aufsetzen und Kontaktieren der Halbleiterchips diese mit möglichst einfachen Werkzeugen ausgestanzt und vereinzelt werden.

Aus der DE 10 2005 044 001 B3 ist ein bandförmiges Trägersubstrat zur Herstellung elektronischer Bauelemente mit Halbleiterchips bekannt, das aus einer strukturierten Kunststofffolie und einer strukturierten Metallfolie, die miteinander laminiert sind, aufgebaut wird. Die Folien weisen unterschiedliche, sich wiederholende Konturen auf, so dass sich das Laminat aus gleichartigen Einheiten zusammensetzt, die das Laminat nach Art einer Parkettierung überdecken.

Die DE 10 2010 005 771 A1 offenbart ein bandförmiges Trägersubstrat, bei dem Verbindungsstege zwischen Elektroden und den umgebenden Restbereichen im Bereich von Kanten der vorstrukturierten Einheiten vorhanden sind. Aus der EP 1 329 952 A2 ist ein Verfahren zum Fixieren von Chipträgern bekannt, bei dem der Chip mit einer Moldmasse eingegossen und mit dem Chipträger verbunden wird, so dass der die Strukturen des Chipträgers freigestanzt werden können, ohne dass sie sich von dem Chip lösen. Mit der JPH06 283 627 A wird ein Rahmen vorzusehen, in den ein Chip eingebaut ist und in dem die Funktionstüchtigkeit des Chips bestimmt werden kann. Die US 2008/265248 A1 offenbart einen weiteren Leiterrahmen zur Kontaktierung und zum Testen von Chips.

Aus der DE 101 48 120 A1 ist ein vorstrukturiertes Trägersubstrat bekannt, das zum Aufbau elektronischer Bauteile verwendet wird. Das dort gezeigte Trägersubstrat umfasst Ausnehmungen, die Strukturen für Elektroden vorgeben.

Die zunächst bestehenden Verbindungen der vorstrukturierten Elektroden und der Aufnahmefläche und dem Rest (wie den Restbereichen) des Trägersubstrats, durch die das Trägersubstrat materiell zusammengehalten wird und durch das eine weitere automatische Prozessierung des Trägersubstrats im Laufe der Fertigung der elektronischen Bauelemente möglich ist oder zumindest erleichtert wird, sind durch Stege gebildet.

Wenn diese Stege schmal genug ausgebildet sind, lassen sie sich durch kompakte Stanzwerkzeuge trennen und so die Elektroden von den Aufnahmeflächen trennen und die elektronischen Bauelemente von dem Rest des Trägersubstrats trennen.

Wenn bei der Prüfung der elektronischen Bauelemente in der Massenfertigung die Kontaktierung des Halbleiterchips überprüft werden soll, während das bandförmige Trägersubstrat noch erhalten ist und damit die Prozessierung in der Massenfertigung erleichtert, muss jede der Einheiten, die Elektroden und eine Aufnahmefläche umfassen zusätzlich noch einen Restbereich (auch Trägerrahmen genannt) umfassen, der dafür sorgt, dass das Trägersubstrat nicht schon bei der Trennung (dem Freistanzen) der Elektroden von den Aufnahmeflächen zerfällt und die Prüfmessung ohne großen Aufwand durchgeführt werden kann.

Aus Kostengründen wird angestrebt, möglichst große Halbleiterchips auf möglichst großen Aufnahmeflächen anzuordnen, ohne die Einheiten dabei zu vergrößern, also ohne zusätzliches Material für das bandförmige Trägersubstrat aufzuwenden.

Nachteilig ist hieran, dass die Stege zwischen den Elektroden und den Restbereichen der Einheiten bei einer Vergrößerung der Aufnahmefläche so dicht beieinander und so dicht bei den anderen Ausnehmungen im Trägersubstrat angeordnet werden, dass bei gegebenem Durchmesser der Stanzwerkzeuge das Trägersubstrat bereits beim Trennen (Freistanzen) der Elektroden von der Aufnahmeflächen zerfällt oder zumindest nicht mehr ohne weiteres prozessierbar ist. Zudem können sich die Aufnahmeflächen und die Elektroden durch das Freistanzen oder durch thermische Effekte beim Fixieren des Halbleiterchips und der Bonddrähte verformen und uneben werden, wodurch die Verbindung des Halbleiterchips zur Aufnahmefläche und die elektrische Kontaktierung des Halbleiterchips verschlechtert werden können. Dies kann zu einer höheren Ausfallrate beziehungsweise Fehlproduktion führen.

Aufgabe der Erfindung ist es, diese und weitere nicht genannte Nachteile zu überwinden. Insbesondere soll eine Strukturierung des Trägersubstrats ermöglicht werden, bei der möglichst große Aufnahmeflächen für größere Halbleiterchips verfügbar sind. Zudem soll die Verformung und das Entstehen von Unebenheiten der Aufnahmeflächen und der Elektroden beim Freistanzen möglichst gering gehalten werden. Gleichzeitig soll aber die Stabilität des Trägersubstrats nicht verschlechtert werden, um die Prozessierung in der Massenfertigung nicht zu beeinträchtigen.

Diese Aufgaben werden gelöst durch ein bandförmiges Trägersubstrat zur Montage mehrerer Halbleiterchips umfassend zumindest eine elektrisch leitende Schicht, die durch Ausnehmungen strukturiert ist, wobei die Ausnehmungen mehrere gleichförmige Einheiten im Trägersubstrat bilden und jede Einheit eine Aufnahmefläche zur Montage zumindest eines Halbleiterchips, einen Restbereich und zwei Elektroden zur Kontaktierung des Halbleiterchips umfasst, die durch die Ausnehmungen vorstrukturiert sind, wobei die Aufnahmeflächen zwischen den Elektroden der gleichen Einheit angeordnet sind und das Trägersubstrat durch eine Parkettierung der Einheiten gebildet ist, wobei die Aufnahmeflächen, die Restbereiche und die Elektroden durch derart schmale Stege miteinander verbunden sind, dass durch Ausstanzen der Stege mit kompakten Stanzwerkzeugen die Aufnahmeflächen von den Elektroden elektrisch isolierbar und die Elektroden und Aufnahmeflächen der Einheiten von den Restbereichen trennbar sind, und zumindest zwei Stege, die die Elektroden mit den Restbereichen verbinden, im Bereich von Ecken der Einheiten angeordnet sind, wobei die Elektroden zwischen den Verankerungsschlitzen und den Ausnehmungen, die die Aufnahmeflächen von den Elektroden trennen, auf einer Seite des Trägersubstrats derart eingeprägt ist, dass die Elektroden zumindest bereichsweise zumindest eine, zwischen zumindest jeweils einem Verankerungsschlitz und der Ausnehmung durchgehende Prägung aufweist und das Trägersubstrat bei den Prägungen eine geringere Dicke aufweist.

Für eine Parkettierung des Trägersubstrats mit Einheiten, werden die Einheiten als flächige Formen gewählt, die die gesamte Fläche des Trägersubstrats lückenlos ausfüllen können. Als Formen der Einheiten werden dafür bevorzugt Vielecke gewählt. Unter einer Ecke einer Einheit werden erfindungsgemäß daher diese Ecken der vieleckigen Einheit verstanden. Unter einer Parkettierung ist eine lückenlose Bedeckung der Fläche des Trägersubstrats ohne Überlappung zu verstehen.

Als elektrisch leitende Schichten finden bevorzugt Metallfolien Anwendung.

Die elektrisch leitende Schicht kann erfindungsgemäß 0,05 mm bis 2 mm dick sein, bevorzugt 0,1 mm bis 0,5 mm, besonders bevorzugt 0,15 mm.

Unter einem schmalen Steg wird erfindungsgemäß ein Steg mit einer Breite von weniger als 1 mm verstanden, vorzugsweise mit einer Breite von weniger als 0,5 mm, besonders bevorzugt mit einer Breite zwischen 0,05 mm und 0,5 mm, ganz besonders bevorzugt mit einer Breite zwischen 0,1 mm und 0,2 mm. Stege diese Breite können dann mit Stanzwerkzeugen, die einen etwas größeren Querschnitt der Schnittfläche aufweisen, ausgestanzt werden. Solche kompakten Stanzwerkzeuge mit einem Querschnitt zwischen 0,1 mm und 2 mm sind gut zur Umsetzung der Herstellungsverfahren für erfindungsgemäße elektronische Bauteile, also zum Trennen der Elektroden und der Aufnahmeflächen voneinander und von den Restbereichen geeignet.

Dabei kann vorgesehen sein, dass die Einheiten rechteckig sind und vorzugsweise vier Stege im Bereich aller Ecken der Einheit angeordnet sind.

Eine Parkettierung mit rechteckigen Einheiten ist besonders einfach zu verarbeiten und im folgenden Herstellungsprozess weiterzuverarbeiten.

Auch kann erfindungsgemäß vorgesehen sein, dass nächste benachbarte Einheiten eine gemeinsame Kante und zwei gemeinsame Ecken aufweisen, wobei die nächsten benachbarten Einheiten nur die nächsten Nachbarn sind, deren Zentren in der Fläche des Trägersubstrats am nächsten zueinander angeordnet sind.

Auch diese Anordnung dient dazu, ein gut zu prozessierendes Trägersubstrat zu erhalten, das eine gute Übersicht während der Verarbeitung ermöglicht.

Ferner kann vorgesehen sein, dass die übernächsten benachbarten Einheiten eine gemeinsame Ecke aufweisen, wobei die übernächsten benachbarten Einheiten nur die übernächsten Nachbarn sind, deren Zentren in der Fläche des Trägersubstrats am zweitnächsten zueinander angeordnet sind.

Durch die so entstehende Symmetrie des Trägersubstrats ist ebenfalls eine einfache Automatisierung der Verarbeitungsprozesse möglich.

Es kann erfindungsgemäß vorgesehen sein, dass der Restbereich jeder Einheit die Elektroden und die Aufnahmefläche der gleichen Einheit umschließt, vorzugsweise vollständig umschließt.

Besonders bevorzugte Ausführungsformen des erfindungsgemäßen Trägersubstrats ergeben sich, wenn vorgesehen ist, dass jede Elektrode eine äußere Kontaktfläche und eine Bondanschlussfläche umfasst, die bereichsweise durch Ausnehmungen in Form von Verankerungsschlitzen zur Verankerung einer Molmasse voneinander getrennt sind.

Hierdurch ist ein besonders robustes und daher leicht zu verarbeitendes elektronisches Bauelement herstellbar.

Ferner kann erfindungsgemäß besonders bevorzugt vorgesehen sein, dass die Elektroden zwischen den Verankerungsschlitzen und den Ausnehmungen, die die Aufnahmeflächen von den Elektroden trennen, auf der unteren Seite des Trägersubstrats, die nicht zur Aufnahme eines Halbleiterchips vorgesehen ist, derart eingeprägt ist, dass die Elektroden zumindest bereichsweise zumindest eine, zwischen zumindest jeweils einem Verankerungsschlitz und der Ausnehmung durchgehende Prägung aufweist und das Trägersubstrat bei den Prägungen eine geringere Dicke aufweist, insbesondere ohne dass an den Randbereichen der Prägung Überstände entstehen, die über die Grenzflächen des restlichen Trägersubstrats hinausragen.

Durch die durchgehenden Prägungen kann die Moldmasse die Bondanschlussflächen zumindest bereichsweise umfließen und so eine noch stärkere Anbindung des Halbleiterchips auf dem Substrat bewirken. Die Moldmasse muss sich dazu nicht über die Grundfläche des Trägersubstrats hinaus erheben, sondern kann in den durch die durchgehenden Prägungen gebildeten Kanälen die Bondanschlussflächen von den Verankerungsschlitzen bis zu den Ausnehmungen, die die Elektroden von den Aufnahmeflächen trennen, umfließen. Die durchgehenden Prägungen bilden dabei auf der Unterseite des Trägersubstrats Vertiefungen. Diese Vertiefungen drücken sich dabei nicht bis auf die Oberseite des Trägersubstrats durch und bilden auch weder auf der Oberseite noch auf der Unterseite vorstehende beziehungsweise überstehende Grate. Die Oberseite des Trägersubstrats ist diejenige Seite, die zur Aufnahme des Halbleiterchips vorgesehen ist.

Erfindungsgemäß kann auch vorgesehen sein, dass die Ausnehmungen zwischen den Aufnahmeflächen und den Elektroden oder zwischen den Aufnahmeflächen und den Restbereichen, bevorzugt benachbart zu jeweils zumindest einem Steg, besonders bevorzugt beidseitig jedes Stegs, jeweils zumindest einen Entlastungsschlitz umfassen, wobei sich die Entlastungsschlitze in die Aufnahmeflächen und/oder die Elektroden hinein erstrecken.

Eine weitere Ausgestaltung der Erfindung kann vorsehen, dass die Ausnehmungen zwischen den Elektroden und den Aufnahmeflächen und/oder den Restbereichen einen Entlastungsschlitz umfassen, der sich in die Elektrode, vorzugsweise in die Bondanschlussfläche hinein erstreckt.

Die Entlastungsschlitze dienen dazu, die Elektroden beziehungsweise die Aufnahmeflächen beim Ausstanzen aber auch beim Aufbringen der Halbleiterchips beziehungsweise der Bonddrähte und der Moldmasse mechanisch zu entlasten. Durch die mechanische Belastung beim Stanzen kann die Ebenheit der Aufnahmeflächen und der Elektroden nachlassen. Die Entlastungsschlitze verhindern eine Verformung der Elektroden beziehungsweise der Aufnahmefläche durch die mechanische Belastung beim Freistanzen (elektrisch oder materiell) und auch durch die thermische Belastung beim Molden oder Bonden. Die Aufnahmeflächen und die Elektroden bleiben so ebener, wodurch fehlerhafte elektronische Bauteile im Vorfeld vermieden werden können.

Besonders bevorzugte Ausführungsformen erfindungsgemäßer Trägersubstrate können sich dadurch auszeichnen, dass die elektrisch leitende Schicht eine Metallfolie ist, vorzugsweise aus Kupfer oder einer Kupfer-Legierung, besonders bevorzugt aus einer Kupfer-Zinn-Legierung.

Die Metallfolie oder ganz im Allgemeinen die elektrisch leitende Schicht kann zusätzlich mit eine weiteren elektrisch leitenden Schicht beschichtet sein, um die Oberfläche des Trägersubstrats zu veredeln. Ebenso kann die elektrisch isolierende Schicht einer zusätzliche elektrisch leitende oder gut wärmeleitende Schicht aufweisen, die auf der von der elektrisch leitenden Schicht gegenüberliegenden Seite der elektrisch isolierenden Schicht angeordnet ist. Diese Schicht kann beispielsweise zur Wärmeabfuhr aus den Halbleiterchips verwendet werden.

Kupfer oder Kupferlegierungen sind zum einen meist kostengünstig und lassen sich zum anderen aber auch besonders gut für die Umsetzung eines Herstellungsprozesses zur Herstellung erfindungsgemäßer Trägersubstrate und elektronischer Bauteile verwenden.

Ferner kann vorgesehen sein, dass auf die elektrisch leitende Schicht eine elektrisch isolierende Schicht laminiert ist, wobei die elektrisch isolierende Schicht vorzugsweise eine Kunststofffolie ist, besonders bevorzugt aus einem PET, PI und/oder Epoxyd.

Die elektrisch isolierende Schicht kann für einige Anwendungen vorteilhaft sein. Zudem stabilisiert die elektrisch isolierende Struktur, da das Laminat stabiler als die elektrisch leitende Schicht alleine ist. Des Weiteren kann die elektrisch leitende Schicht so auch dünner ausgeführt werden.

Es kann erfindungsgemäß vorgesehen sein, dass die Dicke der isolierenden Schicht kleiner als 0,6 mm ist, vorzugsweise 0,01 mm bis 0,2 mm dick ist, besonders bevorzugt 0,03 mm bis 0,1 mm dick ist, ganz besonders bevorzugt 0,05 mm dick ist, insbesondere inklusive einem Klebstoff zum Laminieren.

Auch kann erfindungsgemäß vorgesehen sein, dass die elektrisch leitende Schicht mit einer elektrisch leitenden Dünnschicht aus einem Edelmetall beschichtet ist, vorzugsweise aus Silber, Gold oder einer Legierung daraus oder damit.

Durch eine Beschichtung mit einer Edelmetallschicht, kann sichergestellt werden, dass die Oberfläche des Trägersubstrats nicht so stark oxidiert, dass es zu Fehlern beim Kontaktieren des Halbleiterchips kommen kann.

Es kann erfindungsgemäß vorgesehen sein, dass das Trägersubstrat als Band ausgeformt ist, insbesondere als aufgewickelte Endlosbahn, wobei zwei oder mehrere vorstrukturierte Einheiten nebeneinander angeordnet sind und eine Vielzahl von vorstrukturierten Einheiten hintereinander.

Eine Endlosbahn ist selbstverständlich nicht wirklich endlos sondern nur sehr lang im Vergleich zu ihrer Breite. Solche aufgerollten Bahnen lassen sich bei der Herstellung der Substrate und der elektronischen Bauelemente leicht abspulen und einfach transportieren und damit einfach prozessieren.

Gemäß einer besonders bevorzugten Weiterbildung der Erfindung kann vorgesehen sein, dass die Ausnehmungen in Richtung der Unterseite des Trägersubstrats, die der Oberseite des Trägersubstrats zur Aufnahme der Halbleiterchips gegenüberliegt, geweitet sind, so dass eine auf die Oberseite aufgebrachte Moldmasse, die sich in die Ausnehmungen erstreckt, in den Weitungen verankert wird, wobei vorzugsweise die Weitungen durch Abstufungen und/oder durchgehende Prägungen realisiert sind.

Die Weitungen und die Abstufung sorgen für eine stabilere Verankerung des Halbleiterchips. Zudem muss die Moldmasse durch diese Maßnahme nicht auf der Unterseite der leitfähigen Schicht überstehen, um eine stabile Verankerung zu erzeugen.

Gemäß einer Weiterbildung der Erfindung kann vorgesehen sein, dass das Trägerband beschichtet ist, insbesondere mit einer Dünnschicht, wobei die Beschichtung vorzugsweise aus Silber, einem Edelmetall oder einer Legierung umfassend Silber und/oder ein Edelmetall besteht. Eine solche Beschichtung wird erfindungsgemäß bevorzugt galvanisch auf dem Trägerband aufgetragen.

Die Aufgaben der Erfindung werden auch gelöst durch ein elektronisches Bauelement umfassend zwei Elektroden und eine Aufnahmefläche, hergestellt, insbesondere freigestanzt, aus einem solchen Trägersubstrat, wobei zumindest ein Halbleiterchip auf der Aufnahmefläche befestigt ist, der über Bonddrähte mit den Elektroden, vorzugsweise mit den Bondanschlussflächen der Elektroden, elektrisch kontaktiert ist.

Das erfindungsgemäße elektronische Bauelement umfasst die Vorteile des erfindungsgemäßen Trägersubstrats, so dass die Herstellung und Verarbeitung entsprechend vereinfacht ist.

Als Halbleiterchip kommen verschiedene Ausführüngsförmen in Frage. Diese können einen elektronischen Speicher, beliebige elektronische Schaltungen (integrierte Schaltungen - ICs) oder auch LEDs umfassen. Die elektronischen Bauelemente können Beispielsweise als Chip-Karten wie Bankkarten, Telefonkarten, Ausweise oder auch zum bargeldlosen Bezahlen als funkende Chip-Karten verwendet werden. Dazu können die Elektroden als einfache Kontaktierungen und/oder als Anschlüsse von Antennen zum Übertragen von Signalen verwendet werden.

Es kann erfindungsgemäß vorgesehen sein, dass der zumindest eine Halbleiterchip oder die Halbleiterchips mit einer Moldmasse auf die Aufnahmefläche gemeldet ist oder sind, wobei die Moldmasse vorzugsweise den oder die Halbleiterchips und die Bonddrähte umschließt und sich auf die Elektrode erstreckt, insbesondere die durchgehenden Prägungen umschließt, besonders bevorzugt zumindest bereichsweise die Bondanschlussfläche umschließt und sich durch die Verankerungsschlitze oder die Ausnehmungen hindurch erstreckt.

Hierdurch wird ein besonders stabiles und robustes erfiridungsgemäßes elektronisches Bauelement bereitgestellt. Als Moldmasse kann beispielsweise ein Polymer, wie zum Beispiel ein Epoxid verwendet werden.

Die Aufgaben der Erfindung werden auch gelöst durch ein Verfahren zur Herstellung eines solchen Trägersubstrats, zur Herstellung von Substraten für die Halbleiterchip-Montage oder solcher elektronischer Bauelemente, umfassend die folgenden Schritte:
- Bereitstellen einer bandförmigen Metallfolie,
- Strukturieren der Metallfolie durch Stanzprägen, so dass ein bandförmiges Trägersubstrat erzeugt wird, das durch eine Parkettierung mit gleichartigen Einheiten gebildet wird, die sich wiederholende Ausnehmungen umfassen, wobei jede Einheit zwei Elektroden und eine dazwischen angeordnete Aufnahmefläche sowie einen Restbereich umfassen, die durch schmale Stege miteinander verbunden sind, und wobei jede Elektrode zumindest einen Steg umfasst, der oder die die Elektrode mit dem Restbereich im Bereich von Ecken der Einheiten verbindet, wobei die Elektroden zwischen den Verankerungsschlitzen und den Ausnehmungen, die die Aufnahmeflächen von den Elektroden trennen, auf einer Seite des Trägersubstrats derart eingeprägt werden, so dass die Elektroden zumindest bereichsweise zumindest eine, zwischen zumindest jeweils einem Verankerungsschlitz und der Ausnehmung durchgehende Prägung bildet und das Trägersubstrat bei den Prägungen eine geringere Dicke aufweist.

Dabei kann vorgesehen sein, dass beim Stanzprägen eine Bondanschlussfläche als Teil jeder Elektrode erzeugt wird, die durch Verankerungsschlitze von dem durch eine äußere Kontaktfläche gebildeten Rest der Elektrode bereichsweise getrennt wird, so dass die Bondanschlussflächen zwischen den äußeren Kontaktflächen und den Aufnahmeflächen liegt.

Auch kann erfindungsgemäß besonders bevorzugt vorgesehen sein, dass die Elektroden zwischen den Verankerungsschlitzen und den Ausnehmungen, die die Aufnahmeflächen von den Elektroden trennen, auf der unteren Seite des Trägersubstrats, die nicht zur Aufnahme eines Halbleiterchips vorgesehen ist, eingeprägt werden, so dass die Elektroden zumindest bereichsweise zumindest eine, zwischen zumindest jeweils einem Verankerungsschlitz und der Ausnehmung durchgehende Prägung bildet und das Trägersubstrat bei den Prägungen eine geringere Dicke aufweist, insbesondere ohne dass an den Randbereichen der Prägung Überstände entstehen, die über die Grenzflächen des restlichen Trägersubstrats hinausragen.

Durch diese durchgehenden Prägungen, wird, wie bereits beschrieben, eine stabilere Anbindung des Halbleiterchips auf einem solchen Trägersubstrat ermöglicht und die freigestanzte Elektroden sind mechanisch über die Moldmasse verbunden.

Auch werden die Aufgaben der Erfindung gelöst durch ein Verfahren zur Herstellung eines elektronischen Bauelements, insbesondere eines solchen elektronischen Bauelements, mit einem Trägersubstrat, insbesondere mit einem solchen Trägersubstrat, das mit einem solchen Verfahren hergestellt wurde, umfassend die folgenden chronologischen Schritte:
- Anordnen zumindest eines Halbleiterchips auf einer Aufnahmefläche des Trägersubstrats,
- Kontaktieren des Halbleiterchips mit zumindest einem Bonddraht mit zumindest einer Elektrode des Trägersubstrats, bevorzugt mit zumindest einer Bondanschlussfläche der Elektrode des Trägersubstrats,
- Befestigen des Halbleiterchips mit einer Moldmasse auf dem Trägersubstrat, wobei vorzugsweise der Halbleiterchip und der oder die Bonddrähte durch die Moldmasse abgedeckt werden, und
- Freistanzen des elektronischen Bauelements aus dem Trägersubstrat, so dass jedes elektronische Bauelement zumindest einen Halbleiterchip, eine Aufnahmeflächen und wenigstens zwei Elektroden umfasst

Dabei kann vorgesehen sein, dass das Freistanzen in zwei Schritten erfolgt, wobei zunächst das Trägersubstrat elektrisch freigestanzt wird, so dass die Elektroden von den Aufnahmeflächen elektrisch getrennt werden, anschließend eine Überprüfung der elektrischen Kontaktierung des Halbleiterchips durch die Bonddrähte durchgeführt wird und daran anschließend die elektronischen Bauelemente materiell freigestanzt werden, so dass diese anschließend vereinzelt vorliegen.

Der Erfindung liegt die überraschende Erkenntnis zugrunde, dass bei einer Anordnung der Stege im Bereich der Ecken der Einheiten ausreichend Platz für die Stanzwerkzeuge vorhanden ist, so dass die Aufnahmefläche für den Halbleiterchip bei Beibehaltung der Größe der Elektroden vergrößert werden kann. Gleichzeitig ist das Trägersubstrat aber ausreichend stabil, da jede der Elektroden über mehrere Stege mit den Restbereichen verbunden ist. Da erfindungsgemäß die Elektroden an jeder Ecke der Elektroden getragen sein können, ist die erfindungsgemäße Struktur zusätzlich stabiler. Die Stabilität des Trägersubstrats verhindert eine Beschädigung während der Produktion des elektronischen Bauelements. Dadurch kann ein geringerer Ausschuss bei der Herstellung der Bauelemente erzielt werden.

Die erfindungsgemäßen Stege liegen im Bereich der Ecken der Einheiten. Die Ecken der Einheiten werden durch die Restbereiche beziehungsweise durch Ausnehmungen, die die Restbereiche benachbarter Einheiten voneinander trennen, gebildet. Genaugenommen und anders formuliert liegen die erfindungsgemäßen Stege auf Verbindungslinien zwischen dem Zentrum der Einheit und den Ecken der Einheit. Der Bereich der Ecken der Einheit ist bei erfindungsgemäßen Einheiten innerhalb von 2 mm der Ecke der Einheit, vorzugsweise innerhalb von 1 mm.

Eine weitere überraschende Erkenntnis der Erfindung ist darin zu sehen, dass es durch Entlastungsschlitze im Bereich der Stege in der Elektroden und/oder der Aufnahmefläche gelingt, die mechanische Belastung dieser Flächen zu reduzieren, so dass eine Verformung der Flächen vermieden werden kann. Hierdurch kann der Ausschuss bei der Produktion zusätzlich reduziert werden.

Im Folgenden werden Beispiele, zum besseren Verständnis einiger Aspekte der Erfindung und Ausführungsbeispiele der Erfindung anhand von zehn schematisch dargestellten Figuren erläutert, ohne jedoch dabei die Erfindung zu beschränken. Dabei zeigt:
- Figur 1:: eine schematische Aufsicht auf ein beispielhaftes Trägersubstrat nach dem Stand der Technik;
- Figur 2:: eine schematische Aufsicht auf ein erfindungsgemäßes Trägersubstrat;
- Figur 3:: eine schematische Aufsicht auf ein erfindungsgemäßes Trägersubstrat mit aufgemoldeten Halbleiterchips;
- Figur 4:: eine schematische Aufsicht auf ein elektrisch freigestanztes, erfindungsgemäßes Trägersubstrat mit aufgemoldeten Halbleiterchips;
- Figur 5:: eine schematische Aufsicht auf ein komplett materiell freigestanztes, erfindungsgemäßes Trägersubstrat mit aufgemoldeten Halbleiterchips;
- Figur 6:: eine schematische Aufsicht auf drei freigestanzte, erfindungsgemäße elektronische Bauelemente ohne Restbereiche und Randstreifen des Trägersubstrats;
- Figur 7:: eine schematische Querschnittansicht durch ein erfindungsgemäßes elektronisches Bauelement entlang der Schnittebene A in Figur 6.
- Figur 8:: eine schematische Aufsicht auf ein erfindungsgemäßes Trägersubstrat;
- Figur 9:: eine schematische Aufsicht auf eine Einheit des erfindungsgemäßen Trägersubstrats nach Figur 8; und
- Figur 10:: eine schematische Querschnittansicht durch ein erfindungsgemäßes Trägersubstrat entlang der Schnittebene B in Figur 9.

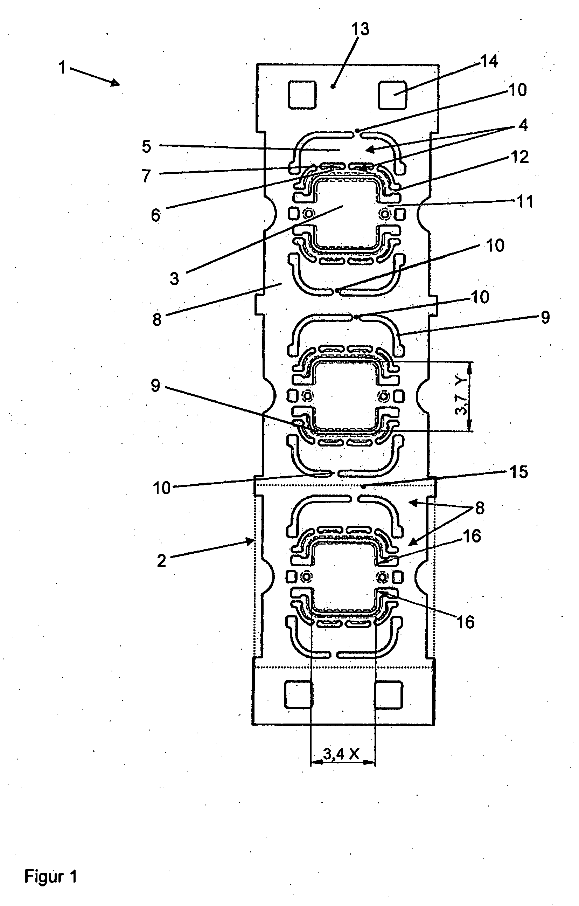

Figur 1 zeigt eine schematische Aufsicht auf ein Trägersubstrat 1 nach dem Stand der Technik. Die Aufsicht erfolgt auf die Oberseite des Trägersubstrats 1, auf der der Halbleiterchip aufgebracht werden soll. Das Trägersubstrat 1 besteht aus einer elektrisch leitenden Metallfolie. Das Trägersubstrat 1 ist aus rechteckigen Einheiten 2 aufgebaut, die in Figur 1, wie auch in den anderen Figuren, durch gepunktete Rechtecke angedeutet sind. Vorliegend sind bei dem Trägersubstrat drei Einheiten 2 gezeigt.

Jede Einheit 2 umfasst eine Aufnahmefläche 3 und jeweils zwei Elektroden 4, die jeweils eine äußere Kontaktfläche 5 und eine Bondanschlussfläche 6 umfassen, wobei diese durch Verankerungsschlitze 7 voneinander bereichsweise getrennt sind. Die restlichen Bereiche des Trägersubstrats 1, die bei der Herstellung der elektronischen Bauelemente mit dem Trägersubstrat 1 schlussendlich entfernt werden und die das Trägersubstrat 1 während des Prozessierens zusammenhalten, werden als Restbereiche 8 bezeichnet. Die Restbereiche 8 umgeben die Elektroden 4 und die Aufnahmefläche 3 jeder Einheit 2. Die Elektroden 4 und die Aufnahmeflächen 3 sowie die Restbereiche 8 sind durch Ausnehmungen 9 im Trägersubstrat vorstrukturiert und durch tragende Stege 10, 11, 12 miteinander verbunden.

Die gestrichelten Linien in den Ausnehmungen 7, 9 deuten an, dass die Ausnehmungen 7, 9 in der Metallfolie nicht durchgehend den gleichen Querschnitt haben, sondern abgestuft sind. Die Ausnehmungen 7, 9 weiten sich also nach unten über eine Abstufung, die durch die gestrichelte Linie angedeutet ist.

Das Trägersubstrat 1 weist am Rand einen Förderstreifen 13 auf, in dem Förderlöcher 14 vorgesehen sind, mit denen das bandförmige Trägersubstrat 1 bei der Herstellung zur automatischen Prozessierung gefördert werden kann. Das bandförmige Trägersubstrat 1 setzt sich zu beiden Seiten (in Figur 1 nach rechts und links) fort, so dass sich weitere Dreier-Einheiten an die gezeigte Dreier-Einheit anschließen. Gezeigt ist also nur ein Abschnitt des gesamten Bandes. Benachbarte Einheiten 2 des gleichen Abschnitts sind durch ein Verbindungselement 15, das durch die Restbereiche 8 beider Einheiten 2 gebildet ist, miteinander verbunden.

Die Stege 10 verbinden die Elektroden 4, beziehungsweise die äußeren Kontaktflächen 5 mit dem Restbereich 8 der gleichen Einheit 2 in Richtung einer benachbarten Einheit 2 (oben beziehungsweise unten). Die Stege 12 verbinden die Elektroden 4 mit dem Restbereich 8 der gleichen Einheit 2, wobei diese in Richtung nicht gezeigter benachbarten Einheiten des Bands weisen (In Figur 1 nach rechts und links). Die Stege 11 verbinden die Aufnahmeflächen 3 mit dem Restbereich 8 der gleichen Einheit 2, wobei diese wiederum in Richtung nicht gezeigter benachbarten Einheiten des Bands weisen (In Figur 1 nach rechts und links). Die Stege 11 münden über Kanten 16 in die Aufnahmeflächen 3, wobei die Kanten 16 auch abgerundet sein können.

Wenn die Aufnahmeflächen 3 vergrößert werden sollen, werden bei gegebener Größe der Elektroden 4 die Verbindungselemente 15 immer schmaler und die Stege 10 rücken dichter zusammen. Da die Stanzwerkzeuge, mit denen die Stege 10, 11, 12 im Laufe des Herstellungsprozesses getrennt werden sollen, eine kompakte, meist kreisförmige Stanzfläche aufweisen, deren Querschnitt aus Gründen der Stabilität und der Toleranzen nicht beliebig klein gestaltet werden kann, läuft man beim elektrischen Freistanzen der Elektroden 4 bei zu schmalen Verbindungselementen 15 in die Gefahr, die Verbindungselemente 15 ungewollt zu trennen und dadurch, den Halterahmen und das Zwischenprodukt mechanisch zu schwächen und eine Qualitätsprüfung zu erschweren oder unmöglich zu machen.

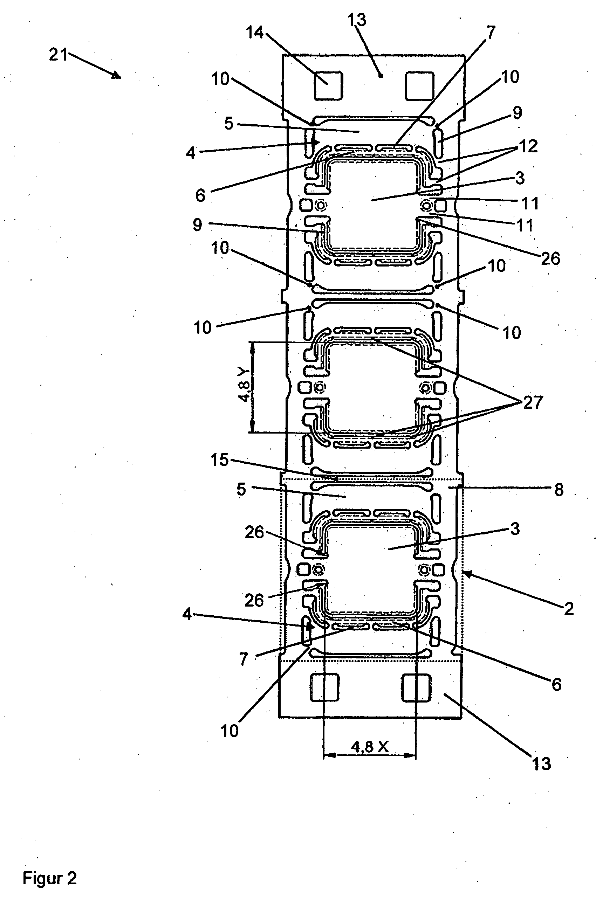

Figur 2 zeigt eine schematische Aufsicht auf ein erfindungsgemäßes Trägersubstrat 21, das dieses Problem und weitere Probleme überwindet. Die Aufsicht erfolgt auf die Oberseite des Trägersubstrats 21, auf der der Halbleiterchip aufgebracht werden soll. Das Trägersubstrat 21 besteht aus einer elektrisch leitenden Metallfolie, die mit einer Goldschicht beschichtet sein kann.

Als Metallfolie kann beispielsweise eine Folie aus einer Kupferlegierung verwendet werden. Die Dicke der Metallfolie kann beispielsweise zwischen 0,1 mm bis 0,5 mm liegen.

Die gestrichelten Linien in den Ausnehmungen 7, 9 deuten an, dass die Ausnehmungen 7, 9 in der Metallfolie nicht durchgehend den gleichen Querschnitt haben, sondern abgestuft sind. Die Ausnehmungen 7, 9 weiten sich also nach unten über eine Abstufung, die durch die gestrichelte Linie angedeutet ist.

Ferner kann auf der Unterseite der Metallfolie eine isolierende Kunststofffolie laminiert sein, indem sie beispielsweise mit der Metallfolie auf der Unterseite verklebt ist. Die Kunststofffolie, die beispielsweise aus PET bestehen kann, hat die breiteren Ausnehmungen (gestrichelte Linien) an den gleichen Stellen, wie die Metallfolie. Die Dicke der Kunststofffolie liegt zwischen 0,02 mm und 0,2 mm.

Das bandförmige Trägersubstrat 21 ist durch eine Parkettierung mit rechteckigen Einheiten 2 gebildet, die am Rand (in Figur 2 oben und unten) mit einem

Förderstreifen 13 abgeschlossen sind. Der Förderstreifen 13 weist Förderlöcher 14 auf, die als Eingriffe für eine Fördereinrichtung dienen. Figur 2 zeigt nur ein einen Abschnitt des gesamten bandförmigen Trägersubstrats 21. Auf der rechten und linken Seite des Trägersubstrats setzt sich das bandförmige Trägersubstrat 21 fort.

Jede Einheit 2 umfasst eine Aufnahmefläche 3 für einen Halbleiterchip oder mehrere Halbleiterchips und zwei Elektroden 4, die die Aufnahmefläche 3 oben und unten umgeben. Die Elektrode 4 ist in zwei Teilbereiche unterteilt und zwar in eine Bondanschlussfläche 6, die zur elektrischen Kontaktierung der Halbleiterchips (nicht gezeigt) mit Hilfe von Bonddrähten (nicht gezeigt) dient, und eine äußere Kontaktfläche 5, an der beispielsweise eine Antenne (nicht gezeigt) oder eine Spannungsversorgung (nicht gezeigt) angeschlossen werden kann. Die Bondanschlussfläche 6 und die äußere Kontaktfläche 5 sind durch Ausnehmungen in Form von Verankerungsschlitzen 7 voneinander getrennt. Die Verankerungsschlitze 7 dienen dazu, dass eine Moldmasse (nicht gezeigt), mit der die Halbleiterchips befestigt werden, hindurchfließen kann und die nach dem Aushärten eine stabile Verankerung bildet.

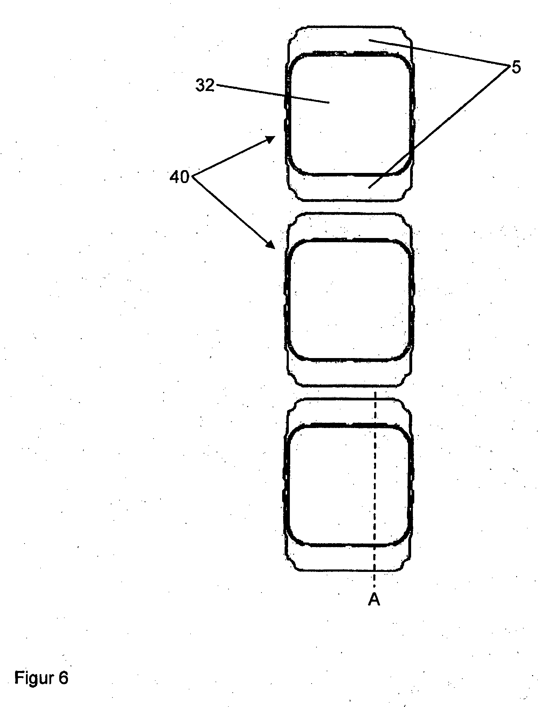

Jede Einheit 2 umfasst ferner Restbereiche 8, die die Elektroden 4 und die Aufnahmefläche umgeben und die für den Zusammenhalt des Trägersubstrats 21 bei der Verarbeitung sorgen. Die Elektroden 4 und die Aufnahmeflächen 3 bilden später einen Teil des aus dem Trägersubstrat 21 aufgebauten elektronischen Bauelements (siehe Figur 6), während die Restbereiche 8 und der Förderstreifen 13 während der Herstellung entfernt werden.

Die Elektroden 4, die Aufnahmeflächen 3 und die Restbereiche 8 der Einheiten 2 sind mit Hilfe von Ausnehmungen 9 vorstrukturiert. Auch die Bondanschlussflächen 6 und die äußeren Kontaktflächen 5 sind durch Ausnehmungen 7 strukturiert, wobei die Verbindungen zwischen den Bondanschlussflächen 6 und den äußeren Kontaktflächen 5 später nicht getrennt werden. Durch die Ausnehmungen 9 erstrecken sich Stege 10, 11, 12, die die Elektroden 4, beziehungsweise die Bondanschlussflächen 6 und die äußeren Kontaktflächen 5, die Aufnahmeflächen 3 und die Restbereiche 8 einer Einheit 2 miteinander verbinden und so die Form und Struktur des bandförmigen Trägersubstrats 21 aufrechterhalten. Das bandförmige Trägersubstrat 21 kann dadurch aufgerollt werden, was die weitere Verarbeitung und damit den Herstellungsprozess der elektronischen Bauelemente vereinfacht.

Dadurch, dass die Stege 10 die äußeren Anschlussflächen 5 der Elektroden 4 mit den Restbereichen 8 im Bereich der Ecken der Einheiten 2 verbinden, wird genügend Platz geschaffen, um ein Ausstanzen mit kompakten Stanzwerkzeugen (Durchmesser der Stanzfläche kleiner als 2 mm) zu ermöglichen. Dadurch ist es möglich, die Elektroden 4 elektrisch von der Aufnahmefläche 3 zu trennen, ohne das Trägersubstrat 21 als Ganzes zu trennen. Es besteht daher keine Gefahr, die Verbindungselemente 15 und damit den Trägerrahmen an den Grenzen der Einheiten 2 zueinander zu trennen und so die weitere Verarbeitung und Prüfung der elektronischen Bauelemente während der Herstellung zu beeinträchtigen oder sogar zu verhindern.

Durch diese Maßnahme ist es möglich, die Verbindungselemente 15 schmaler zu gestalten und so mehr Platz für die Aufnahmeflächen 3 bei gleicher Größe der Elektroden 4 und gleicher Breite des Trägersubstrats 21 einzuräumen. Bei gleichem Materialaufwand können so platzsparend größere Halbleiterchips auf den Aufnahmeflächen 3 angeordnet und befestigt werden, wobei gleichzeitig die Massenfertigung durch Verwendung leicht zu fördernder bandförmiger Trägersubstrate 21 erhalten bleibt. Im Vergleich zu dem Trägersubstrat 1 nach Figur 1 hat das Trägersubstrat 21 also eine größere Aufnahmefläche 3. Während die Abmessungen der Aufnahmefläche 3 des Trägersubstrats 1 nach Figur 1 3,4 X Breite und 3,7 Y Höhe betragen, hat die Aufnahmefläche 3 des Trägersubstrats 21 nach Figur 2 mit der bevorzugten Anordnung der Stege 10 eine Breite von 4,8 X und eine Höhe von 4,8 Y. Dabei sind X und Y Längeneinheiten, die von der Größe der Trägersubstrate 1, 21 abhängen. Es kann für X und Y beispielsweise 1 mm angenommen werden. Bei gleicher äußerer Abmessung der Trägersubstrate 1, 21, stellt das Trägersubstrat 21 also eine um 41 % breitere und um 30% höhere Aufnahmefläche zur Verfügung, so dass eine 83% größere Fläche zur Aufnahme von Halbleiterchips bei gleicher Breite des bandförmigen Trägersubstrats 1, 21 und bei gleicher Größe der Elektroden 4 zur Verfügung steht.

Beispielsweise kann die Länge und Breite einer erfindungsgemäßen Aufnahmefläche 3 zwischen 1 mm und 10 mm liegen, vorzugsweise circa 5 mm. Die Breite eines bandförmigen Trägersubstrats 21 kann zwischen 20 mm und 100 mm liegen, vorzugsweise zwischen 30 mm und 50 mm. Diese Größenangaben beziehen sich auf erfindungsgemäße Trägersubstrate im Allgemeinen und sollen nicht auf das vorliegende Ausführungsbeispiel beschränkt verstanden werden. Die Breite des bandförmigen Trägersubstrats 21 liegt in Figur 2 in Y-Richtung. Die Länge des bandförmigen Trägersubstrats 21 (in X-Richtung) ist größer, es setzt sich also in X-Richtung mit gleichartigen jeweils drei nebeneinander liegenden Einheiten 2 fort. Das Trägersubstrat 21 kann zur Verarbeitung aufgerollt werden und kann zwischen 10 cm und etlichen Metern lang sein.

Des Weiteren umfassen die Ausnehmungen 9 Entlastungsschlitze 26, 27, die sich in die Aufnahmeflächen 3 beziehungsweise die Bondkontaktflächen 6 hinein erstrecken. Die Entlastungsschlitze 26, 27 öffnen die schmaleren oberen Bereiche der Ausnehmungen 7, 9 in die Aufnahmeflächen 3 beziehungsweise die Bondkontaktflächen 6. Durch diese Entlastungsschlitze 26, 27 kann eine Verformung der Aufnahmefläche 3 und der Elektroden 4 beim Ausstanzen der Stege 10, 11, 12 und schon zuvor beim Ausstanzen der Ausnehmungen 7, 9 verhindert werden. Ebenso kann eine thermische induzierte Verformung beziehungsweise Unebenheit der Flächen 3, 4, 5, 6 beim Verbinden des Halbleiterchips verhindert oder zumindest reduziert werden. Die Verformung ist unerwünscht, da sie eine zuverlässige Kontaktierung und Montage der Halbleiterchips erschwert.

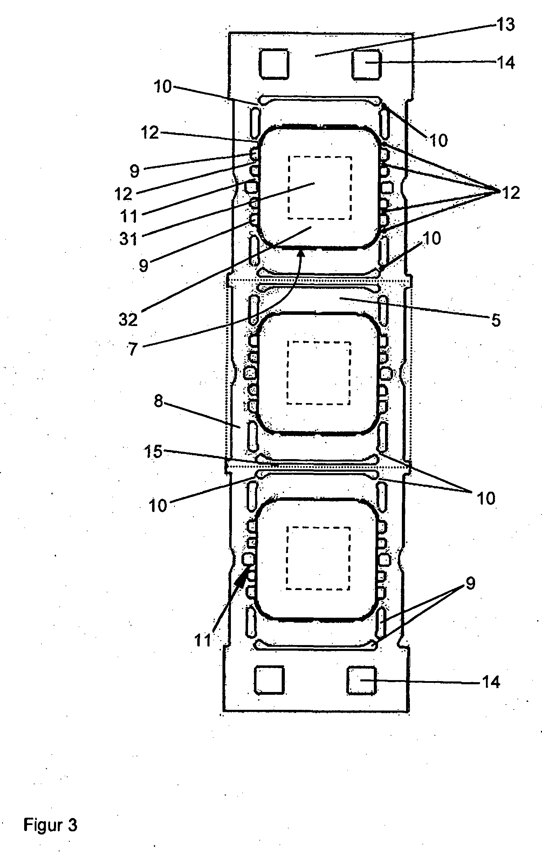

Im Folgenden wird die Herstellung erfindungsgemäßer elektronischer Bauelemente unter Verwendung eines erfindungsgemäßen Trägersubstrats 21 wie nach Figur 2 anhand der Figuren 3 bis 6 erläutert.

Zunächst wird jeweils ein Halbleiterchip 31 auf die gezeigte Oberseite der Aufnahmeflächen 3 einer jeden Einheit 2 aufgesetzt und dort befestigt, indem der Halbleiterchip 31 beispielsweise festgeklebt wird. Anschließend wird der Halbleiterchip 31 mit Bonddrähten (nicht gezeigt) mit den Bondanschlussflächen 6 verbunden. Danach werden der Halbleiterchip 31 und die Bonddrähte fixiert, indem eine Moldmasse 32, beispielsweise ein Epoxid aufgetragen wird. Beim Molden des Halbleiterchips 31 und der Bonddrähte läuft die Moldmasse 32 auch in die Verankerungsschlitze 7 und die Ausnehmungen 9, so dass die Moldmasse 32 gut in dem Trägersubstrat 21 verankert ist und den Halbleiterchip 31 festhält, nachdem die Moldmasse 32 ausgehärtet ist.

Dieser so entstandene Aufbau ist in Figur 3 als schematische Aufsicht gezeigt, wobei der von der Moldmasse 32 umschlossene und daher innenliegende Halbleiterchip 31 durch ein gestricheltes Rechteck angedeutet ist. Die unmittelbar im Bereich der Moldmasse 32 liegenden Ausnehmungen 9 sind ebenfalls von der Moldmasse 32 durchflossen und Wirken aufgrund der Abstufung dann als Verankerung des Halbleiterchips 31.

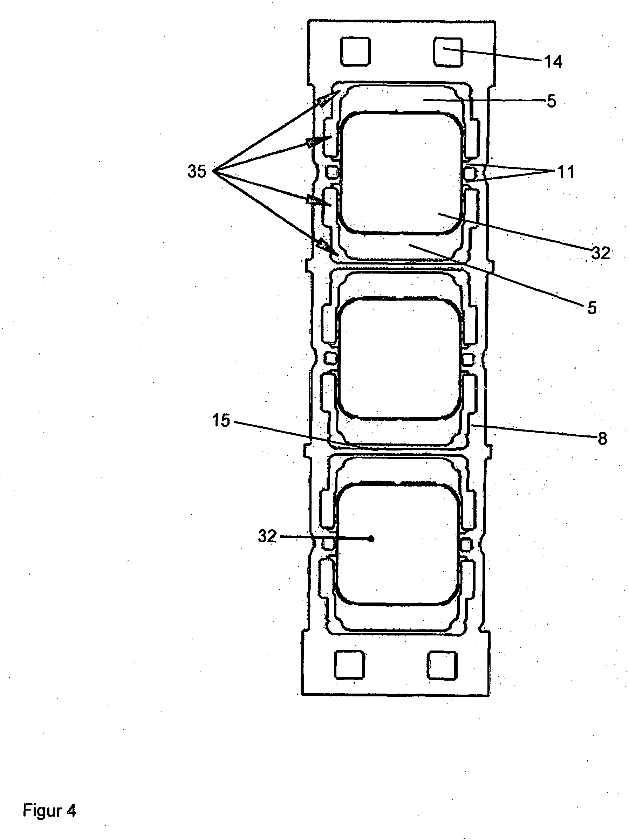

Anschließend wird der in Figur 3 gezeigte Aufbau elektronisch freigestanzt. Dabei werden die Stege 10, 12, die die Elektroden 4 mit den Restbereichen 8 materiell und elektrisch leitend verbinden, mit einem Stanzwerkzeug heraus gestanzt. Dieser Zustand ist in Figur 4 in einer schematischen Aufsicht gezeigt. Die elektronischen Freistanzungen 35 bewirken, dass die äußeren Kontaktflächen 5 und die Bondanschlussflächen 6, also die Elektroden 4 nicht mehr elektrisch leitend mit der Aufnahmefläche 3 oder dem Restbereich 8 verbunden sind.

Die Verbindungselemente 15 und die Restbereiche 8 sowie die Stege 11 bewirken dabei, dass die gesamte Struktur noch einigermaßen stabil zusammenhängt und so weiter Verarbeitet werden kann. Anschließend kann die elektrische Kontaktierung der Halbleiterchips 31 zu den Elektroden 4 serienmäßig überprüft werden, um fehlerhafte Bauelemente 40 frühzeitig zu erkennen und später aussortieren zu können. Die betroffenen Einheiten 2 können dazu markiert werden.

In einem nächsten Schritt werden die elektronischen Bauelemente 40 aus dem Trägersubstrat 21 herausgetrennt, indem mit materiellen Freistanzungen 36 die Stege 11 ausgestanzt und dabei die elektronischen Bauelemente 40 freigestanzt werden. Neben einer materiellen Freistanzung 36 mit einem Stempel oder einem anderen Stanzwerkzeug könnten auch andere Verfahren angewendet werden, wie beispielsweise Schneiden oder Laserschneiden.

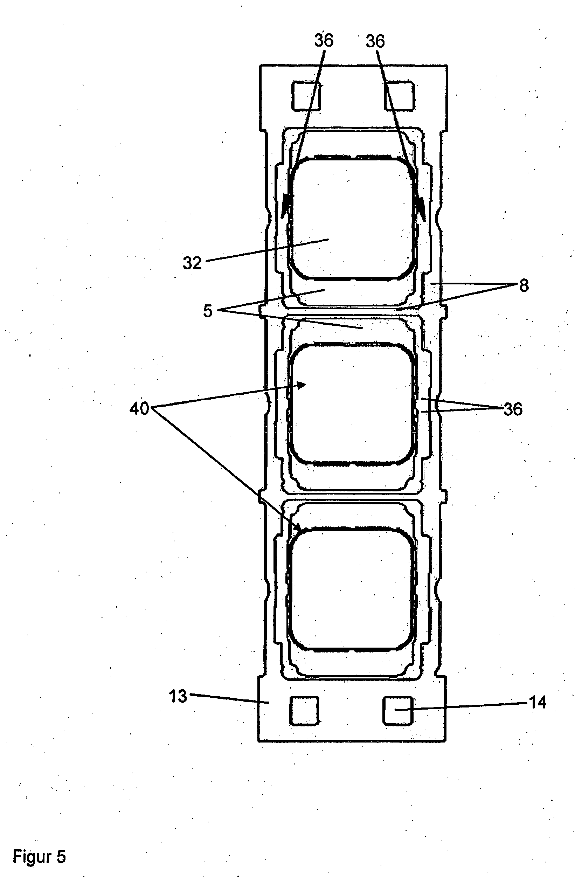

Dieser Zustand, in dem die elektronischen Bauelemente 40 umfassend die Moldmasse 32, die Halbleiterchips 31 und die äußeren Anschlussflächen 5 von den Restbereichen 8 und den Förderstreifen 13 freigestanzt sind, ist in Figur 5 als schematische Aufsicht gezeigt. Figur 6 zeigt schließlich als schematische Aufsicht die drei vereinzelten elektronischen Bauelemente 40, die mit den drei Einheiten 2 des Trägersubstrats 21 herstellt wurden. Die elektronischen Bauelemente 40 können anschließend verbaut werden, indem beispielswiese Drähte oder Leiterbahnen als Antennen oder elektrische Stromleitungen mit den äußeren Anschlussflächen 5 verbunden werden.

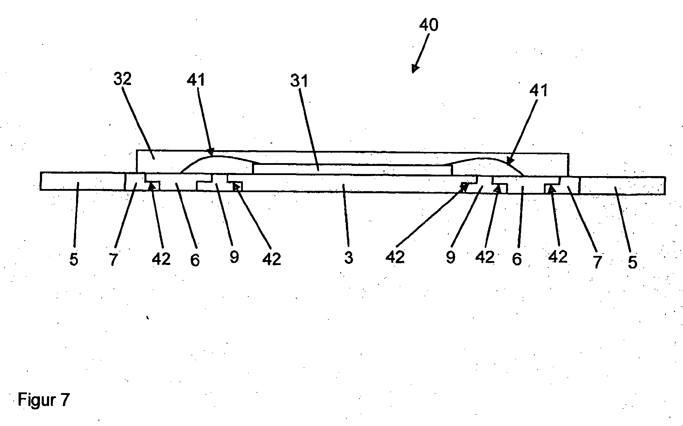

Figur 7 zeigt eine schematische Querschnittansicht eines erfindungsgemäßen Bauteils 40 entlang eines Schnitts A, der Anhand der gestrichelten Linie in Figur 6 gezeigt ist. Das elektronische Bauteil 40 umfasst an der Unterseite die Aufnahmefläche 3, die äußeren Kontaktflächen 5 und die Bondanschlussflächen 6. Dazwischen sind Ausnehmungen 9 und Verankerungsschlitze 7 angeordnet, die mit der Moldmasse 32 gefüllt sind. Die Moldmasse 32 bedeckt auch einen Halbleiterchip 31, der auf der Aufnahmefläche 3 aufgeklebt ist. Der Halbleiterchip 31 ist über Bonddrähte 41 mit den Bondanschlussflächen 6 kontaktiert. Die Moldmasse 32 umschließt auch die Bonddrähte 41.

Die Verankerungsschlitze 7 weisen auf einer, der Mitte des elektronischen Bauteils 40 zugewandten Seite eine Abstufung 42 auf, die die Verankerungsschlitze 7 in Richtung der Unterseite weitet. Die Ausnehmungen 9, die die Aufnahmefläche 3 elektrisch von der Bondanschlussfläche 6 beziehungsweise der Elektrode 5, 6 trennt, weisen beidseitig ebensolche Abstufungen 42 auf, so dass auch diese in Richtung der Unterseite des elektronischen Bauteils 40 beziehungsweise in Richtung der Unterseite des Trägersubstrats geweitet sind.

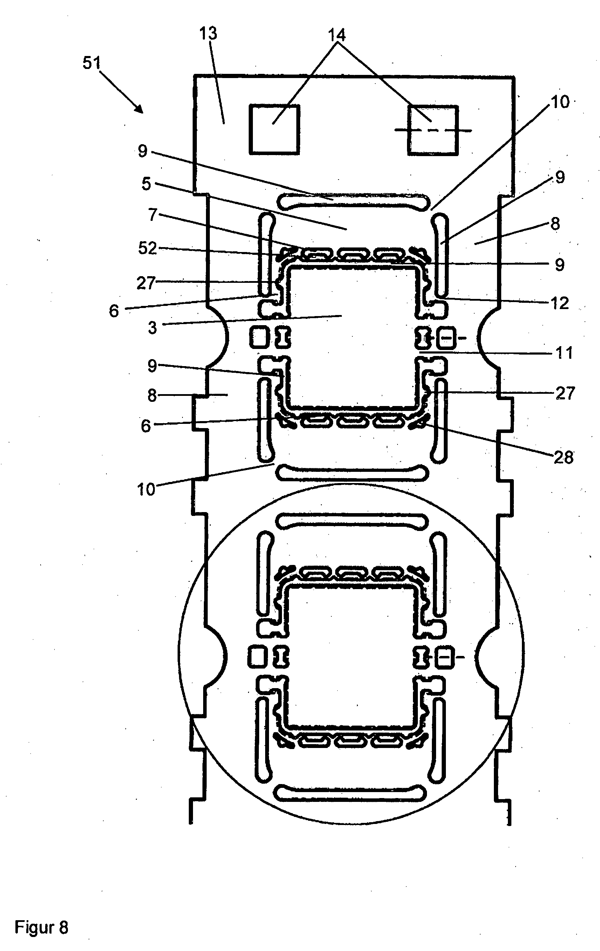

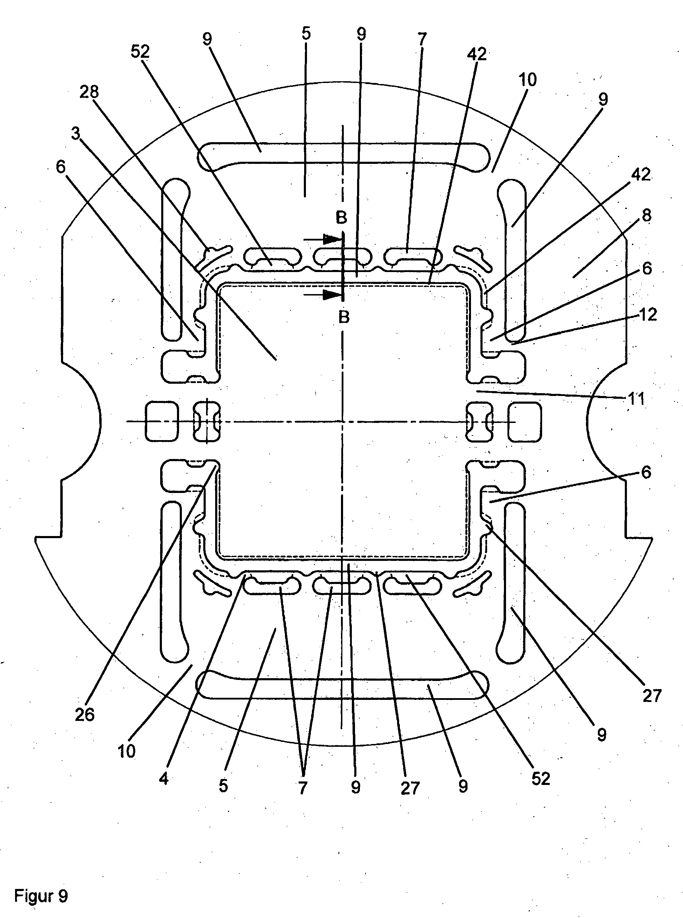

Figur 8 zeigt eine schematische Aufsicht auf ein erfindungsgemäßes Trägersubstrat 51 oder genauer auf einen Ausschnitt auf ein erfindungsgemäßes Trägersubstrat- 51 umfassend zwei Einheiten. Eine der Einheiten, die in Figur 8 durch einen Kreis eingerahmt ist, ist in Figur 9 als eine schematische Aufsicht des erfindungsgemäßen Trägersubstrats 51 nach Figur 8 gezeigt. Das Trägersubstrat 51 beziehungsweise die Einheiten sind ähnlich den in Figur 2 gezeigten Einheiten 2 beziehungsweise dem Trägersubstrat 21 aufgebaut. Das Trägersubstrat 51 besteht aus einer dünnen Metallfolie, die einseitig mit einem Edelmetall galvanisch beschichtet ist.

Jede Einheit des Trägersubstrats 51 umfasst eine zentrale Aufnahmefläche 3 zur Aufnahme eines Halbleiterchips und zwei Elektroden 4, die jeweils eine äußere Kontaktfläche 5 und Bondanschlussflächen 6 umfassen. Die Elektroden sind durch jeweils eine Ausnehmung 9 von der Aufnahmefläche 3 getrennt. Die Aufnahmeflächen 3, die äußeren Kontaktflächen 5 und die Bondanschlussflächen 6 sind gemeinsam von einem Restbereich 8 der Einheit umgeben und durch äußere Ausnehmungen 9 bereichsweise voneinander getrennt.

Die äußeren Kontaktflächen 5 sind über Stege 10 mit den Restbereichen 8 verbunden, die Bondanschlussflächen 6 sind über Stege 12 mit den Restbereichen 8 verbunden und die Aufnahmeflächen 3 sind über Stege 11 mit den Restbereichen 8 verbunden, so dass das Trägersubstrat 51 eine zusammenhängende Schicht bildet. Sowohl in den Ausnehmungen 9, als auch in den Verankerungsschlitzen 7 sind Entlastungsschlitze 26, 27, 28 vorgesehen. Die Entlastungsschlitze 26 erstrecken sich in die Aufnahmeflächen 3, die Entlastungsschlitze 27 erstrecken sich in die Bondanschlussflächen 6 beziehungsweise die Elektroden 4 und die Entlastungsschlitze 28 erstrecken sich in die äußeren Kontaktflächen 3. Alle Entlastungsschlitze 26, 27, 28 dienen dazu, das Trägersubstrat 51 insbesondere beim Bestücken mit Halbleiterchips und bei der späteren Verwendung, beispielsweise dem Befestigen eines auf der Trägerstruktur 51 befestigten und anschließend freigestanzten Chips auf einer Plastikkarte zum Erzeugen eines elektronischen Ausweises, vor Verformungen zu schützen.

Die in Figur 9 dargestellten gestrichelten Bereiche der Elektroden 4 zwischen den Verankerungsschlitzen 7 und der Ausnehmung 9, die die Aufnahmefläche 3 begrenzt, sind Prägungen 52 beziehungsweise Haltestege 52, die durchgehend von den Verankerungsschlitzen 7 bis zu den Ausnehmungen 9 reichen. Weitere Bereiche, die durch gestrichelte Linien dargestellt sind, sind die auch aus Figur 2 bekannten Abstufungen 42, die ebenfalls von der Unterseite des Trägersubstrats 51 eingeprägt sind. In den gestrichelten Bereichen 42, 52 ist das Trägersubstrat 51 also dünner, wobei Material von der Unterseite des Trägersubstrats 51 fehlt.

Die eingeprägten Bereiche 42, 52 sind zum Anschließen eines Bondrahts schlechter geeignet, da mit den Prägungen 42, 52 eine Verformung der Elektroden 4 einhergeht, die für eine zuverlässige Befestigung von Bonddrähten ungeeignet ist, und da bei bevorzugten Bondtechniken ein stabilerer Untergrund benötigt benötigt wird, als den, den die eingeprägten Bereiche 42, 52 zur Verfügung stellen. Daher sind die Bondflächen 6 bevorzugt an den gezeigten Stellen in der Nähe der Stege 12 angeordnet.

Das Trägersubstrat 51 ist auf beiden Seiten (in den Figuren 8 und 9 die Fläche, auf die der Betrachter schaut und die gegenüberliegende Fläche) bis auf die Einprägungen 42, 52 eben. Dies kann durch eine Stanzprägung zur Herstellung aller Ausnehmungen 7, 9, mit den Entlastungsschlitzen 26, 27, 28 und den Prägungen 42, 52 erreicht werden, die in einem Herstellungsschritt durchgeführt werden. Das Trägersubstrat 51 kann durch ein galvanisches Bad gefahren werden, wobei die freie metallische Oberfläche des Trägersubstrats 51 mit einem Edelmetall galvanisiert wird. Dadurch, dass das Trägersubstrat 51 keine Vorsprünge aufweist, werden Dichtungen des galvanischen Bads und andere Bauteile zur Beförderung des Trägerbands 51 nach der Stanzprägung, durch keine vorstehenden Teile abgenutzt oder beschädigt. Ein erfindungsgemäßes Trägerband 51 führt also zu einem weniger wartungsintensiven Herstellungsverfahren.

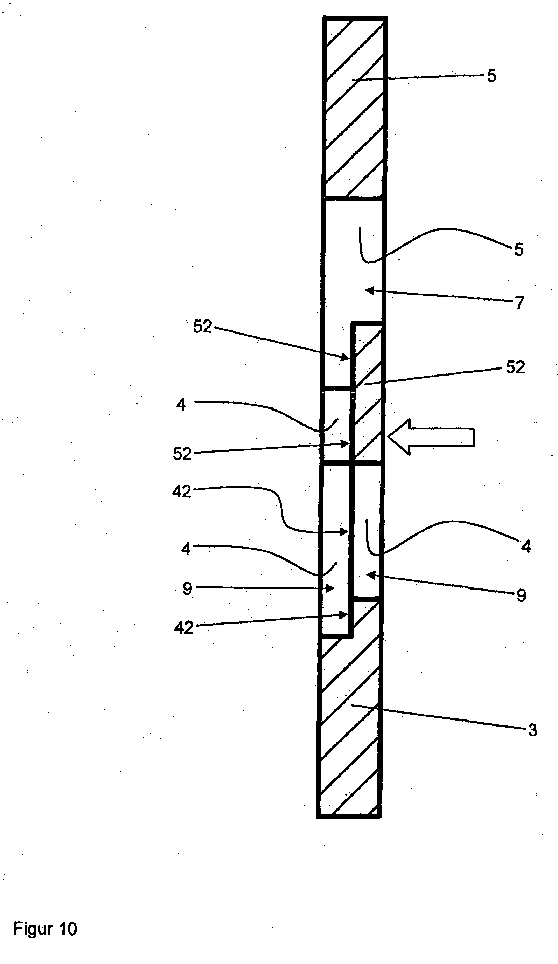

Figur 10 zeigt eine schematische Querschnittansicht durch ein erfindungsgemäßes Trägersubstrat 51 entlang der Schnittebene B in Figur 9. Darin ist gut erkennbar, dass im Trägersubstrat 51 keine Vorsprünge durch die Stanzprägung auftreten beziehungsweise vorhanden sind. Die gestrichenen Bereiche sind die Querschnittsflächen der Aufnahmefläche 3, des Haltestegs 52 und der äußeren Kontaktfläche 5 nach Figur 9. Bei einer Blickrichtung, die in Figur 9 durch die beiden Pfeile angedeutet ist, sieht der Betrachter bei dem gezeigten Schnitt entlang der Fläche B-B in Figur 9 wegen der Ausnehmung 9 zwischen der Elektrode 4 und der Aufnahmefläche 3 auf die mit einer Abstufung 42 abgestufte Elektrode 4. Ferner ist ein Blick auf die Stege der äußeren Kontaktfläche 5 möglich, die die äußere Kontaktfläche 5 mit der restlichen Elektrode 4 verbindet. Dieser Blick wird durch die Verankerungsschlitze 7 möglich. Auch die Aufnahmefläche 3 ist mit einer Abstufung 42 abgestuft.

Gut ist auch die durchgehende Prägung 52 beziehungsweise der Haltesteg 52 zu erkennen, die die Elektrode 4bereichsweise aufweist. Die durchgehenden Prägungen 52 verbinden innerhalb der Grenzen der beiden äußeren Grenzflächen des Trägersubstrats 51 (in Figur 10 links und rechts) die Ausnehmung 9 zwischen der Elektrode 4und der Aufnahmefläche 3 mit Verankerungsschlitzen 7. Dadurch kann eine Moldmasse sich um die Haltestege 52 herum erstrecken und dadurch eine besonders stabile Verbindung erreichen. Gleichzeitig kann die Moldmasse derart aufgetragen werden, dass diese sich ebenfalls nicht über die äußeren Grenzflächen des Trägersubstrats 51 erhebt. Der große, Weiß ausgefüllte Pfeil stellt die Blickrichtung des Betrachters in den Figuren 8 und 9 dar.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1,21,51: Trägersubstrat
- 2: Einheit
- 3: Aufnahmefläche
- 4: Elektrode
- 5: Äußere Kontaktfläche
- 6: Bondanschlussfläche
- 7: Verankerungsschlitz / Ausnehmung / Ausstanzung
- 8: Restbereich
- 9: Ausnehmung / Ausstanzung
- 10, 11, 12: Steg
- 13: Förderstreifen
- 14: Förderloch
- 15: Verbindungselement
- 16: Kante
- 26, 27, 28: Entlastungsschlitz
- 31: Halbleiterchip
- 32: Moldmasse
- 35: Elektronische Freistanzung
- 36: Vollständige Freistanzung
- 40: Elektronisches Bauelement
- 41: Bonddraht
- 42: Abstufung
- 52: Durchgehende Prägung / Haltestege
- A: Schnittebene für Querschnittansicht von Figur 7
- B: Schnittebene für Querschnittansicht von Figur 10

## Patentansprüche

1. Bandförmiges Trägersubstrat (1, 21, 51) zur Montage mehrerer Halbleiterchips (31) umfassend zumindest eine elektrisch leitende Schicht, die durch Ausnehmungen (7, 9) strukturiert ist, wobei die Ausnehmungen (7, 9) mehrere gleichförmige Einheiten (2) im Trägersubstrat (1, 21, 51) bilden und jede Einheit (2) eine Aufnahmefläche (3) zur Montage zumindest eines Halbleiterchips (31), einen Restbereich (8) und zwei Elektroden (4) zur Kontaktierung des Halbleiterchips (31) umfasst, die durch die Ausnehmungen (7, 9) vorstrukturiert sind, wobei die Aufnahmeflächen (3) zwischen den Elektroden (4) der gleichen Einheit (2) angeordnet sind und das Trägersubstrat (1, 21, 51) durch eine Parkettierung der Einheiten (2) gebildet ist, wobei
die Aufnahmeflächen (3), die Restbereiche (8) und die Elektroden (4) durch derart schmale Stege (10, 11, 12) miteinander verbunden sind, dass durch Ausstanzen der Stege (10, 11, 12) mit kompakten Stanzwerkzeugen die Aufnahmeflächen (3) von den Elektroden (4) elektrisch isolierbar und die Elektroden (4) und Aufnahmeflächen (3) der Einheiten (2) von den Restbereichen (8) trennbar sind, und das
die Elektroden (4) zwischen den Verankerungsschlitzen (7) und den Ausnehmungen (9), die die Aufnahmeflächen (3) von den Elektroden (4) trennen, auf einer Seite des Trägersubstrats (1, 21, 51) derart eingeprägt ist, dass die Elektroden (4) zumindest bereichsweise zumindest eine, zwischen zumindest jeweils einem Verankerungsschlitz (7) und der Ausnehmung (9) durchgehende Prägung (52) aufweist und das Trägersubstrat (1, 21, 51) bei den Prägungen (52) eine geringere Dicke aufweist, **dadurch gekennzeichnet, dass** zumindest zwei Stege (10), die die Elektroden (4) mit den Restbereichen (8) verbinden, im Bereich von Ecken der Einheiten (2) angeordnet sind.

2. Trägersubstrat (1, 21, 51) nach Anspruch 1, **dadurch gekennzeichnet, dass** die Einheiten (2) rechteckig sind und vorzugsweise vier Stege (10) im Bereich aller Ecken der Einheit (2) angeordnet sind.

3. Trägersubstrat (1, 21, 51) nach Anspruch 1 oder 2, **dadurch gekennzeichnet, dass**
nächste benachbarte Einheiten (2) eine gemeinsame Kante und zwei gemeinsame Ecken aufweisen, wobei die nächsten benachbarten Einheiten (2) nur die nächsten Nachbarn sind, deren Zentren in der Fläche des Trägersubstrats (1, 21, 51) am nächsten zueinander angeordnet sind.

4. Trägersubstrat (1, 21, 51) nach einem der vorangehenden Ansprüche, **dadurch gekennzeichnet, dass**
die übernächsten benachbarten Einheiten (2) eine gemeinsame Ecke aufweisen, wobei die übernächsten benachbarten Einheiten (2) nur die übernächsten Nachbarn sind, deren Zentren in der Fläche des Trägersubstrats, (1, 21, 51) am zweitnächsten zueinander angeordnet sind.

5. Trägersubstrat (1, 21, 51) nach einem der vorangehenden Ansprüche, **dadurch gekennzeichnet, dass**
jede Elektrode (4) eine äußere Kontaktfläche (5) und eine Bondanschlussfläche (6) umfasst, die bereichsweise durch Ausnehmungen (7) in Form von Verankerungsschlitzen (7) zur Verankerung einer Moldmasse (32) voneinander getrennt sind.

6. Trägersubstrat (1, 21, 51) nach einem der vorangehenden Ansprüche, **dadurch gekennzeichnet, dass**
die Elektroden (4) zwischen den Verankerungsschlitzen (7) und den Ausnehmungen (9), die die Aufnahmeflächen (3) von den Elektroden (4) trennen, auf der unteren Seite des Trägersubstrats (1, 21, 51), die nicht zur Aufnahme eines Halbleiterchips (31) vorgesehen ist, derart eingeprägt ist, dass die Elektroden (4) zumindest bereichsweise zumindest eine, zwischen zumindest jeweils einem Verankerungsschlitz (7) und der Ausnehmung (9) durchgehende Prägung (52) aufweist und das Trägersubstrat (1, 21, 51) bei den Prägungen (52) eine geringere Dicke aufweist, insbesondere ohne dass an den Randbereichen der Prägung (52) Überstände vorhanden sind, die über die Grenzflächen des restlichen Trägersubstrats (1, 21, 51) hinausragen.

7. Trägersubstrat (1, 21, 51) nach einem der vorangehenden Ansprüche, **dadurch gekennzeichnet, dass**
die Ausnehmungen (9) zwischen den Aufnahmeflächen (3) und den Elektroden (4) und/oder zwischen den Aufnahmeflächen (3) und den Restbereichen (8), bevorzugt benachbart zu jeweils zumindest einem Steg (11), besonders bevorzugt beidseitig jeden Stegs (11), jeweils zumindest einen Entlastungsschlitz (26) umfassen, wobei sich die Entlastungsschlitze (26) in die Aufnahmeflächen (3) hinein erstrecken.

8. Trägersubstrat (1, 21, 51) nach einem der vorangehenden Ansprüche, **dadurch gekennzeichnet, dass**
die Ausnehmungen (9) zwischen den Elektroden (4) und den Aufnahmeflächen (3) und/oder den Restbereichen (8) einen Entlastungsschlitz (27, 28) umfassen, der sich in die Elektrode (4), vorzugsweise in die Bondanschlussfläche (6) hinein erstreckt.

9. Trägersubstrat (1, 21, 51) nach einem der vorangehenden Ansprüche, **dadurch gekennzeichnet, dass**
die elektrisch leitende Schicht eine Metallfolie ist, vorzugsweise aus Kupfer oder einer Kupfer-Legierung, besonders bevorzugt aus einer Kupfer-Zinn-Legierung.

10. Trägersubstrat (1, 21, 51) nach einem der vorangehenden Ansprüche, **dadurch gekennzeichnet, dass**
auf die elektrisch leitende Schicht eine elektrisch isolierende Schicht laminiert ist, wobei die elektrisch isolierende Schicht vorzugsweise eine Kunststofffolie ist, besonders bevorzugt aus einem PET, PI und/oder Epoxyd und/oder die elektrisch leitende Schicht mit einer elektrisch leitenden Dünnschicht aus einem Edelmetall beschichtet ist, vorzugsweise aus Gold oder einer Goldlegierung.

11. Trägersubstrat (1, 21, 51) nach einem der vorangehenden Ansprüche, **dadurch gekennzeichnet, dass**
die Ausnehmungen (7, 9) in Richtung der Unterseite des Trägersubstrats (1, 21, 51), die der Oberseite des Trägersubstrats (1, 21, 51) zur Aufnahme der Halbleiterchips (31) gegenüberliegt, geweitet sind, so dass eine auf die Oberseite aufgebrachte Moldmasse (32), die sich in die Ausnehmungen (7, 9) erstreckt, in den Weitungen verankert wird, wobei vorzugsweise die Weitungen durch Abstufungen (42) und/oder durchgehende Prägungen (52) realisiert sind.

12. Elektronisches Bauelement (40) umfassend zwei Elektroden (4) und eine Aufnahmefläche (3), eines Trägersubstrats (1, 21, 51) nach einem der vorangehenden Ansprüche, **dadurch gekennzeichnet, dass**
zumindest ein Halbleiterchip (31) auf der Aufnahmefläche (3) befestigt ist, der über Bonddrähte (41) mit den Elektroden (4), vorzugsweise mit den Bondanschlussflächen (6) der Elektroden (4), elektrisch kontaktiert ist.

13. Elektronisches Bauelement (40) nach Anspruch 12, **dadurch gekennzeichnet, dass**
der zumindest eine Halbleiterchip (31) oder die Halbleiterchips (31) mit einer Moldmasse (32) auf die Aufnahmefläche (3) gemoldet ist oder sind, wobei die Moldmasse (32) vorzugsweise den oder die Halbleiterchips (31) und die Bonddrähte (41) umschließt und sich auf die Elektrode (4) erstreckt, insbesondere die durchgehenden Prägungen (52) umschließt, besonders bevorzugt zumindest bereichsweise die Bondanschlussfläche (6) umschließt und sich durch die Verankerungsschlitze (7) oder die Ausnehmungen (7, 9) hindurch erstreckt.

14. Verfahren zur Herstellung eines bandförmigen Trägersubstrats (1, 21, 51) nach einem der Ansprüche 1 bis 11, zur Herstellung von Substraten für die Halbleiterchip-Montage oder elektronischen Bauelementen (40) nach einem der Ansprüche 12 oder 13, umfassend die folgenden Schritte:
Bereitstellen einer bandförmigen Metallfolie,
Strukturieren der Metallfolie durch Stanzprägen, so dass ein bandförmiges Trägersubstrat (1, 21, 51) erzeugt wird, das durch eine Parkettierung mit gleichartigen Einheiten (2) gebildet wird, die sich wiederholende Ausnehmungen (7, 9) umfassen, wobei jede Einheit (2) zwei Elektroden (4) und eine dazwischen angeordnete Aufnahmefläche (3) sowie einen Restbereich (8) umfassen, die durch schmale Stege (10, 11, 12) miteinander verbunden sind, und wobei die Elektroden (4) zwischen den Verankerungsschlitzen (7) und den Ausnehmungen (9), die die Aufnahmeflächen (3) von den Elektroden (4) trennen, auf einer Seite des Trägersubstrats (1, 21, 51) derart eingeprägt werden, so dass die Elektroden (4) zumindest bereichsweise zumindest eine, zwischen zumindest jeweils einem Verankerungsschlitz (7) und der Ausnehmung (9) durchgehende Prägung (52) bildet und das Trägersubstrat (1, 21, 51) bei den Prägungen (52) eine geringere Dicke aufweist, **dadurch gekennzeichnet, dass**
jede Elektrode (4) zumindest einen Steg (10) umfasst, der oder die die Elektrode (4) mit dem Restbereich (8) im Bereich von Ecken der Einheiten (2) verbindet.

15. Verfahren nach Anspruch 14, **dadurch gekennzeichnet, dass**
beim Stanzprägen eine Bondanschlussfläche (6) als Teil jeder Elektrode (4) erzeugt wird, die durch Verankerungsschlitze (7) von dem durch eine äußere Kontaktfläche (5) gebildeten Rest der Elektrode (4) bereichsweise getrennt wird, so dass die Bondanschlussflächen (6) zwischen den äußeren Kontaktflächen (5) und den Aufnahmeflächen (3) liegt.

16. Verfahren nach Anspruch 14 oder 15, **dadurch gekennzeichnet, dass**
die Elektroden (4) zwischen den Verankerungsschlitzen (7) und den Ausnehmungen (9), die die Aufnahmeflächen (3) von den Elektroden (4) trennen, auf der unteren Seite des Trägersubstrats (1, 21, 51), die nicht zur Aufnahme eines Halbleiterchips (31) vorgesehen ist, eingeprägt werden, so dass die Elektroden (4) zumindest bereichsweise zumindest eine, zwischen zumindest jeweils einem Verankerungsschlitz (7) und der Ausnehmung (9) durchgehende Prägung (52) bildet und das Trägersubstrat (1, 21, 51) bei den Prägungen (52) eine geringere Dicke aufweist, insbesondere ohne dass an den Randbereichen der Prägung (52) Überstände entstehen, die über die Grenzflächen des restlichen Trägersubstrats (1, 21, 51) hinausragen.

17. Verfahren zur Herstellung eines elektronischen Bauelements (40), insbesondere nach einem der Ansprüche 12 oder 13, mit einem Trägersubstrat (1, 21, 51), insbesondere nach einem der Ansprüche 1 bis 11, das mit einem Verfahren nach einem der Ansprüche 14 bis 16 hergestellt wurde, umfassend die folgenden chronologischen Schritte:
Anordnen zumindest eines Halbleiterchips (31) auf einer Aufnahmefläche (3) des Trägersubstrats (1, 21, 51),
Kontaktieren des Halbleiterchips (31) mit zumindest einem Bonddraht (41) mit zumindest einer Elektrode (4) des Trägersubstrats (1, 21, 51), bevorzugt mit zumindest einer Bondanschlussfläche (6) der Elektrode (4) des Trägersubstrats (1, 21, 51),
Befestigen des Halbleiterchips (31) mit einer Moldmasse (32) auf dem Trägersubstrat (1,21, 51), wobei vorzugsweise der Halbleiterchip (31) und der oder die Bonddrähte (41) durch die Moldmasse (32) abgedeckt werden, und Freistanzen des elektronischen Bauelements (40) aus dem Trägersubstrat (1, 21, 51), so dass jedes elektronische Bauelement (40) zumindest einen Halbleiterchip (31), eine Aufnahmefläche (3) und wenigstens zwei Elektroden (4) umfasst.

18. Verfahren nach Anspruch 17, **dadurch gekennzeichnet, dass**
das Freistanzen in zwei Schritten erfolgt, wobei zunächst das Trägersubstrat (1, 21, 51) elektrisch freigestanzt wird, so dass die Elektroden (4) von den Aufnahmeflächen (3) elektrisch getrennt werden,
anschließend eine Überprüfung der elektrischen Kontaktierung des Halbleiterchips (31) durch die Bonddrähte (4) durchgeführt wird und daran anschließend die elektronischen Bauelemente (40) materiell freigestanzt werden, so dass diese anschließend vereinzelt vorliegen.

## Claims

1. A tape-type carrier substrate (1, 21, 51) for mounting a plurality of semiconductor chips (31), comprising at least one electrically conductive layer structured by recesses (7, 9), wherein the recesses (7, 9) form a plurality of uniform units (2) in the carrier substrate (1, 21, 51) and each unit (2) comprises a receiving area (3) for mounting at least one semiconductor chip (31), a residual region (8) and two electrodes (4) for contacting the semiconductor chip (31), which are pre-structured by the recesses (7, 9), wherein the receiving areas (3) are arranged between the electrodes (4) of the same unit (2) and the carrier substrate (1, 21, 51) is formed by a tessellation of the units (2), wherein
the receiving areas (3), the residual regions (8) and the electrodes (4) are interconnected by webs (10, 11, 12) that are so narrow that, by means of the webs (10, 11, 12) being stamped out using compact stamping tools, the receiving areas (3) can be electrically insulated from the electrodes (4) and the electrodes (4) and receiving areas (3) of the units (2) can be separated from the residual regions (8), and
the electrodes (4) between the anchoring slits (7) and the recesses (9), which separate the receiving areas (3) from the electrodes (4), are embossed on a side of the carrier substrate (1, 21, 51) in such a way that the electrodes (4) at least in regions have at least one continuous embossment (52) between in each case at least one anchoring slit (7) and the recess (9), and the carrier substrate (1, 21, 51) has a smaller thickness at the embossments (52), **characterised in that**
at least two webs (10) that connect the electrodes (4) to the residual regions (8) are arranged in the region of corners of the units (2).

2. The carrier substrate (1, 21, 51) according to Claim 1, **characterised in that** the units (2) are rectangular and preferably four webs (10) are arranged in the region of all corners of the unit (2).

3. The carrier substrate (1, 21, 51) according to Claim 1 or 2, **characterised in that**
closest adjacent units (2) have a common edge and two common corners, wherein the closest adjacent units (2) are only the closest neighbours of which the centres are arranged closest to one another in the area of the carrier substrate (1, 21, 51).

4. The carrier substrate (1, 21, 51) according to one of the preceding claims, **characterised in that**
the next-but-one adjacent units (2) have a common corner, wherein the next-but-one adjacent units (2) are merely the next-but-one neighbours of which the centres are arranged second-closest to one another in the area of the carrier substrate (1, 21, 51).

5. The carrier substrate (1, 2, 51) according to one of the preceding claims, **characterised in that**
each electrode (4) comprises an outer contact area (5) and a bonding connection area (6), which are separated from one another in regions by recesses (7) in the form of anchoring slits (7) for anchoring a mould compound (32).

6. The carrier substrate (1, 21, 51) according to one of the preceding claims, **characterised in that**
the electrodes (4) between the anchoring slits (7) and the recesses (9), which separate the receiving areas (3) from the electrodes (4), are embossed on the underside of the carrier substrate (1,21, 51), which is not provided to receive a semiconductor chip (31), in such a way that the electrodes (4) at least in regions have at least one continuous embossment (52) between in each case at least one anchoring slit (7) and the recess (9), and the carrier substrate (1, 21, 51) has a smaller thickness at the embossments (52), in particular without the creation of protrusions at the edge regions of the embossment (52) that protrude beyond the boundaries of the rest of the carrier substrate (1, 21, 51).

7. The carrier substrate (1, 21, 51) according to one of the preceding claims, **characterised in that**
the recesses (9) between the receiving areas (3) and the electrodes (4) and/or between the receiving areas (3) and the residual regions (8) each comprise at least one relief slit (26), preferably adjacent in each case to at least one web (11), particularly preferably on either side of each web (11), wherein the relief slits (26) extend into the receiving areas (3).

8. The carrier substrate (1, 21, 51) according to one of the preceding claims, **characterised in that**
the recesses (9) between the electrodes (4) and the receiving areas (3) and/or the residual regions (8) comprise a relief slit (27, 28), which extends into the electrode (4), preferably into the bonding connection area (6).

9. The carrier substrate (1, 21, 51) according to one of the preceding claims, **characterised in that**
the electrically conductive layer is a metal film, preferably consisting of copper or a copper alloy, particularly preferably consisting of a copper-tin alloy.

10. The carrier substrate (1, 21, 51) according to one of the preceding claims, **characterised in that**
an electrically insulating layer is laminated onto the electrically conductive layer, wherein the electrically insulating layer is preferably a plastic film, particularly preferably consisting of a PET, PI and/or epoxy and/or the electrically conductive layer is coated with an electrically conductive thin film consisting of a noble metal, preferably consisting of gold or a gold alloy.

11. The carrier substrate (1, 21, 51) according to one of the preceding claims, **characterised in that**
the recesses (7, 9) are widened in the direction of the underside of the carrier substrate (1, 21, 51), which is opposite the upper side of the carrier substrate (1, 21, 51) for receiving the semiconductor chips (31), such that a mould compound (32) applied to the upper side and extending into the recesses (7, 9), is anchored in the widened portions, wherein the widened portions are preferably formed by gradations (42) and/or continuous embossments (52).

12. An electronic component (40) comprising two electrodes (4) and a receiving area (3) produced from a carrier substrate (1, 21, 51) according to one of the preceding claims, **characterised in that**
at least one semiconductor chip (31) is fastened on the receiving area (3) and is electrically contacted via bonding wires (41) to the electrodes (4), preferably to the bonding connection areas (6) of the electrodes (4).

13. The electronic component (40) according to Claim 12, **characterised in that** the at least one semiconductor chip (31) or the semiconductor chips (31) is/are moulded with a mould compound (32) onto the receiving area (3), wherein the mould compound (32) preferably encloses the semiconductor chip (31) or semiconductor chips (31) and the bonding wires (41) and extends onto the electrode (4), in particular encloses the continuous embossments (52), particularly preferably surrounds the bonding connection area (6) at least in regions and extends through the anchoring slits (7) or the recesses (7, 9).

14. A method for producing a tape-type carrier substrate (1, 21, 51) according to one of Claims 1 to 11, for producing substrates for semiconductor chip assembly or electronic components (40) according to one of Claims 12 or 13, comprising the following steps:
providing a tape-type metal film,
structuring the metal film by stamping and embossing, such that a tape-type carrier substrate (1, 21, 51) is produced that is formed by a tessellation with uniform units (2) which comprise recurrent recesses (7, 9), wherein each unit (2) comprises two electrodes (4) and a receiving area (3) arranged therebetween and also a residual region (8), which are interconnected by narrow webs (10, 11, 12), and wherein each electrode (4) comprises at least one web (10), which connects the electrode or electrodes (4) to the residual region (8) in the region of corners of the units (2), wherein the electrodes (4) are embossed between the anchoring slits (7) and the recesses (9), which separate the receiving areas (3) from the electrodes (4), on a side of the carrier substrate (1, 21, 51), such that the electrodes (4), at least in regions, form at least one continuous embossment (52) between in each case at least one anchoring slit (7) and the recess (9), and the carrier substrate (1, 21, 51) has a smaller thickness at the embossments (52).

15. The method according to Claim 14, **characterised in that**,
during the stamping and embossing, a bonding connection area (6) is produced as part of each electrode (4) and is separated in regions by anchoring slits (7) from the rest of the electrode (4) formed by an outer contact area (5) such that the bonding connection areas (6) are arranged between the outer contact areas (5) and the receiving areas (3).

16. The method according to Claim 14 or 15, **characterised in that** the electrodes (4) are embossed between the anchoring slits (7) and the recesses (9), which separate the receiving areas (3) from the electrodes (4), on the lower side of the carrier substrate (1, 21, 51), which is not provided in order to receive a semiconductor chip (31), such that the electrodes (4), at least in regions, form at least one continuous embossment (52) between in each case at least one anchoring slit (7) and the recess (9), and the carrier substrate (1, 21, 51) has a smaller thickness at the embossments (52), in particular without creating at the edge regions of the embossment (52) protrusions that protrude beyond the boundaries of the rest of the carrier substrate (1, 21, 51).

17. A method for producing an electronic component (40), in particular according to one of Claims 12 or 13, comprising a carrier substrate (1, 21, 51), in particular according to one of Claims 1 to 11, which has been produced using a method according to one of Claims 14 to 16, comprising the following chronological steps:
arranging at least one semiconductor chip (31) on a receiving area (3) of the carrier substrate (1,21, 51),
contacting the semiconductor chip (31) via at least one bonding wire (41) to at least one electrode (4) of the carrier substrate (1, 21, 51), preferably with at least one bonding connection area (6) of the electrode (4) of the carrier substrate (1, 21, 51),
fastening the semiconductor chip (31) via a mould compound (32) on the carrier substrate (1, 21, 51), wherein the semiconductor chip (31) and the bonding wire or bonding wires (41) are preferably covered by the mould compound (32), and
stamping free the electronic component (40) from the carrier substrate (1, 21, 51), such that each electronic component (40) comprises at least one semiconductor chip (31), a receiving area (3) and at least two electrodes (4).

18. The method according to Claim 17, **characterised in that**
the electronic component is stamped free in two steps, wherein the carrier substrate (1, 21, 51) is first stamped free electrically, such that the electrodes (4) are electrically separated from the receiving areas (3),
then the electrical contacting of the semiconductor chip (31) by means of the bonding wires (41) is checked, and
the electronic components (40) are then stamped free materially, such that they are then present individually.

## Revendications

1. Substrat support (1, 21, 51) en forme de bande pour le montage de plusieurs puces de semi-conducteur (31) comprenant au moins une couche conductrice électriquement qui est structurée par des évidements (7, 9), où les évidements (7, 9) forment plusieurs unités (2) de même forme dans le substrat support (1, 21, 51) et chaque unité (2) comprend une surface de réception (3) pour le montage d'au moins une puce de semi-conducteur (31), une région résiduelle (8) et deux électrodes (4) pour la mise en contact avec la puce de semi-conducteur (31), qui sont structurées préalablement par les évidements (7, 9), où les surfaces de réception (3) sont disposées entre les électrodes (4) de la même unité (2) et le substrat support (1, 21, 51) est formé par un pavage des unites (2), où
les surfaces de réception (3), les régions résiduelles (8) et les électrodes (4) sont reliées ensemble par des âmes (10, 11, 12) si minces que, par un estampage des âmes (10, 11, 12) avec des outils d'estampage compacts, les surfaces de réception (3) peuvent être isolées électriquement des électrodes (4) et des surfaces de réception (3) des unités (2) peuvent être séparées des régions résiduelles (8), et les électrodes (4) entre les fentes d'ancrage (7) et les évidements (9), qui séparent les séparent les surfaces de réception (3) des électrodes (4), sont ancrées sur une face du substrat support (1, 21, 51) de telle manière que les électrodes (4) présentent au moins partiellement au moins une empreinte (52) traversante entre au moins respectivement une fente d'ancrage (7) et l'évidement (9) et le substrat support (1, 21, 51) présente une épaisseur réduite près des empreintes (52), **caractérisé en ce qu'**au moins deux âmes (10) qui relient les électrodes (4) avec les régions résiduelles (8) sont disposées dans la région des coins des unites (2).

2. Substrat support (1, 21, 51) selon la revendication 1, **caractérisé en ce que** les unités (2) sont rectangulaires et de préférence quatre âmes (10) sont disposées dans la région de tous les coins de l'unité (2).

3. Substrat support (1, 21, 51 ) selon la revendication 1, ou 2, **caractérisé en ce que**
des unités (2) immédiatement voisines présentent une arête commune et deux coins communs, où les unités (2) immédiatement voisines ne sont que des voisines immédiates dont les centres sont disposés les plus proches l'un de l'autre dans la surface du substrat support (1,21, 51).

4. Substrat support (1, 21, 51) selon l'une des revendications précédentes, **caractérisé en ce que**
les unités (2) voisines au deuxième degré présentent un coin commun, où les unités (2) voisines au deuxième degré ne sont que les voisines au deuxième degré dont les centres sont disposés voisins au deuxième degré sur la surface du substrat support (1,21, 51).

5. Substrat support (1, 21, 51) selon l'une des revendications précédentes, **caractérisé en ce que**
chaque électrode (4) comprend une surface de contact (5) extérieure et une surface de connexion au fond (6), qui sont séparées l'une de l'autre partiellement par des évidements (7) sous la forme de fentes d'ancrage (7) pour l'ancrage d'une masse moulée (32).

6. Substrat support (1, 21, 51) selon l'une des revendications précédentes, **caractérisé en ce que**
les électrodes (4) entre les fentes d'ancrage (7) et les évidements (9), qui séparent les surfaces de réception (3) des électrodes (4) sont estampées sur la face inférieure du substrat support (1, 21, 51) qui n'est pas prévue pour la réception d'une puce de semi-conducteur (31) de telle manière que les électrodes (4)présentent au moins partiellement au moins une empreinte (52) traversant une fente d'ancrage (7) et l'évidement (9) et le substrat support (1, 21, 51) présente une épaisseur réduite auprès des empreintes (52), en particulier, sans que des résidus ne restent présents sur des régions de bordure de l'empreinte (52), qui dépassent par-dessus les surfaces limitrophes du substrat support résiduel (1,21, 51).

7. Substrat support (1, 21, 51) selon l'une des revendications précédentes, **caractérisé en ce que**
les évidements (9) entre les surfaces de réception (3) et les électrodes (4), et/ou entre les surfaces de réception (3) et les régions résiduelles (8), de préférence au voisinage d'au moins une âme (11) respective, de manière particulièrement préférée, des deux côtés de chaque âme (11), comprennent respectivement au moins une fente de délestage (26), où les fentes de délestage (26) s'étendent à l'intérieur dans les surfaces de réception (3).

8. Substrat support (1, 21, 51) selon l'une des revendications précédentes, **caractérisé en ce que**
les évidements (9) entre les électrodes (4) et les surfaces de réception (3) et/ou les régions résiduelles (8) comprennent une fente de délestage (27, 28) qui s'étend à l'intérieur dans la électrode (4) de préférence à l'intérieur dans la surface de connexion au fond (6).

9. Substrat support (1, 21, 51) selon l'une des revendications précédentes, **caractérisé en ce que**
la couche électriquement conductrice est un film métallique, de préférence en cuivre ou dans un alliage de cuivre, de manière particulièrement préférée, dans un alliage de cuivre et de zinc.

10. Substrat support (1, 21, 51) selon l'une des revendications précédentes, **caractérisé en ce**
**qu'**une couche isolante électriquement est stratifiée sur la couche électriquement conductrice, où la couche isolante électriquement est de préférence un film de matière plastique, de manière particulièrement préférée une couche en PET, en PI et/ou en époxyde, et/ou la couche électriquement conductrice est revêtue d'une couche mince électriquement conductrice en métal noble, de préférence en or ou dans un alliage d'or.

11. Substrat support (1, 21, 51) selon l'une des revendications précédentes, **caractérisé en ce que**
les évidements (7, 9) sont étendus en direction de la face inférieure du substrat support (1, 21, 51) qui est située en face de la face supérieure du substrat support (1, 21, 51) pour la réception des puces de semi-conducteur (31), élargis de sorte qu'une masse moulée (32) rapportée sur la face supérieure qui s'étend dans les évidements (7, 9), est ancrée dans les élargissements, où de préférence les élargissements sont réalisés par des niveaux (42) et/ou des empreintes (52) traversantes.

12. Composant électronique (40) comprenant deux électrodes (4) et une surface de réception (3), un substrat support (1, 21, 51) selon l'une des revendications précédentes, **caractérisé en ce qu'**au moins une puce de semi-conducteur (31) est fixée sur la surface de réception (3) qui est en contact électriquement avec les électrodes (4), de préférence avec les surface de connexion au fond (6) des électrodes (4) par l'intermédiaire de fils de liaison (41).

13. Composant électronique (40) selon la revendication 12, **caractérisé en ce que** l'au moins une puce de semi-conducteur (31) ou les puces de semi-conducteur (31) sont moulées sur la surface de réception (3) avec une masse moulée (32), où la masse moulée (32) entoure de préférence la puce ou les puces de semi-conducteur (31) et les fils de liaison (41), et s'étend sur l'électrode (4), en particulier entoure les empreintes (52) traversantes, de manière particulièrement préférée, entoure au moins partiellement la surface de raccordement de liaison (6) et s'étend à travers les fentes d'ancrage (7) ou les évidements (7, 9).

14. Procédé de fabrication d'un substrat support (1, 21, 51) en forme de bande selon l'une des revendications 1 à 11, pour la fabrication de substrats pour le montage de puces de semi-conducteur ou de composants électroniques (40) selon l'une des revendications 12 ou 13, comprenant les étapes suivantes :
mise à disposition d'un film métallique en forme de bande,
structuration du film métallique par estampage d'empreintes de sorte qu'un substrat support (1, 21, 51) en forme de bande est créé, qui est formé par un pavage avec des unités (2) du même type qui comprennent des évidements (7, 9) se répétant, où chaque unité (2) comprend deux électrodes (4) et une surface de réception (3) disposée entre elles, ainsi qu'une région résiduelle (8), qui sont reliées ensemble par des âmes (10, 11, 12) fines, et où les électrodes entre les fentes d'ancrage (7) et les évidements (9) qui séparent les surfaces de réception (3) des électrodes sont estampées de telle manière sur une face du substrat support (1, 21, 51) que les électrodes (4) forment au moins partiellement au moins une empreinte (52) traversante entre au moins une fente d'ancrage (7) respective et l'évidement (8) et le substrat support (1, 21, 51) présente une épaisseur réduite près des empreintes (52), **caractérisé en ce que**
chaque électrode (4) comprend au moins une âme (10) qui relie l'électrode (4) avec la région résiduelle (8) dans la zone des coins des unités (2).

15. Procédé selon la revendication 14, **caractérisé en ce que** lors de l'estampage d'empreintes, une surface de raccordement de liaison (6) est créée en tant que partie d'électrode (4), qui est séparée partiellement du reste de l'électrode (4) formé par une surface de contact (5) extérieure par les fentes d'ancrages (7) de sorte que les surfaces de raccordement de liaison (6) se situent entre les surfaces de contact (5) extérieures et les surfaces de réception (3).

16. Procédé selon la revendication 14, ou 15, **caractérisé en ce que** les électrodes (4) entre les fentes d'ancrage (7) et les évidements (9) qui séparent les surfaces de réception (3) des électrodes (4), sont estampées sur la face inférieure du substrat support (1, 21, 51) qui n'est pas prévue pour la réception d'une puce de semi-conducteur (31) sont estampées de telle manière que les électrodes (4) forment au moins partiellement au moins une empreinte (52) traversante entre au moins une fente d'ancrage (7) respective et l'évidement (9) et le substrat support (1, 21, 51) présente une épaisseur réduite près des empreintes (52), en particulier sans que des résidus ne se produisent dans des régions de bordure de l'empreinte (52), qui dépassent par dessus la surface limitrophe du substrat support (1, 21, 51) restant.

17. Procédé de fabrication d'un composant électronique (40) en particulier selon l'une des revendications 12 ou 13, avec un substrat support (1, 21, 51), en particulier, selon l'une des revendications 1 à 11, qui a été fabriqué d'après un procédé selon l'une des revendications 14 à 16, comprenant les étapes chronologiques suivantes :
disposition d'au moins une puce de semi-conducteur (31) sur une surface de réception (3) du substrat support (1, 21, 51),
mise en contact de la puce de semi-conducteur (31) avec au moins un fil de liaison (41) avec au moins une électrode (4) du substrat support (1,21, 51), de préférence avec au moins une surface de raccordement de liaison (6) de l'électrode (4) du substrat support (1,21, 51),
fixation de la puce de semi-conducteur (31) avec une mase de moulage (32) sur le substrat support (1,21, 51), où de préférence la puce de semi-conducteur v(31) et le fil ou les fils de liaison (41) sont recouverts par la masse moulée (32), et
estampage du composant électronique (40) à partir du substrat support (1, 21, 51) de sorte que chaque composant électronique (40) comprend au moins une puce de semi-conducteur (31), une surface de réception (3) et au moins deux électrodes (4).

18. Procédé selon la revendication 17, **caractérisé en ce que**
l'estampage est effectué en deux étapes, où d'abord le substrat support (1, 21, 51) est estampé électriquement de sorte que les électrodes (4) sont séparées électriquement des surfaces de réception (3),
ensuite un examen du contact électrique de la puce de semi-conducteur (31) est effectué par les fils de liaison (41) et ensuite les composants électroniques (40) fixés dessus sont libérés de sorte que ceux-ci se présentent ensuite de manière individuelle.
